# EUROPEAN PATENT APPLICATION

(11) **EP 4 407 669 A1**
(43) Date of publication of application: **31.07.2024**
(21) Application number: 24154349.5
(22) Date of filing: 29.01.2024
(51) Int. Cl.: H01L 21/768, H01L 21/8234, H01L 23/528, H01L 23/535, H01L 29/423

(54) **INTEGRATED CIRCUIT DEVICE**

(30) Priority: 30.01.2023 KR 20230011866
(71) Applicant: Samsung Electronics Co., Ltd., Suwon-si, Gyeonggi-do 16677 (KR)
(72) Inventor: HWANG, Donghoon, 16677 Suwon-si (KR); HWANG, Inchan, 16677 Suwon-si (KR); KIM, Hyojin, 16677 Suwon-si (KR)
(74) Representative: Marks & Clerk LLP

(57) **Abstract**

An integrated circuit device is provided. The device includes: lower source/drain areas; lower contacts respectively on bottom surfaces of the lower source/drain areas; upper source/drain areas spaced apart from the lower source/drain areas in a vertical direction; upper contacts respectively on upper surfaces of the upper source/drain areas; and a first vertical conductive rail electrically connected to a first contact of the lower contacts and the upper contacts, the first vertical conductive rail extending in the vertical direction, and including a first portion having a first upper surface at a first vertical level and a second portion having a second upper surface at a second vertical level lower than the first vertical level. The second portion overlaps a first upper contact among the upper contacts in the vertical direction.

## Description

### BACKGROUND

The present disclosure relates to an integrated circuit device, and more particularly, to an integrated circuit device including a field effect transistor.

High-capacity integrated circuit devices are needed to address demand for miniaturization, multifunctionality, and high performance of electronic products, and increased integration is needed to provide high-capacity integrated circuit devices. For example, small-sized field effect transistors may reduce the area of an integrated circuit, but the operation speed thereof may decrease due to the complexity of a line structure needed to provide the small size. Thus, in order to achieve the functions and operation speed required in integrated circuit devices, there is a need for an integrated circuit device which provides both a high integration degree and performance.

### SUMMARY

One or more embodiments provide an integrated circuit device including a field effect transistor with improved integration degree and electrical performance.

The invention provides in one aspect, an integrated circuit device including: a plurality of lower source/drain areas; a plurality of lower contacts respectively on bottom surfaces of the plurality of lower source/drain areas; a plurality of upper source/drain areas spaced apart from the plurality of lower source/drain areas in a vertical direction; a plurality of upper contacts respectively on upper surfaces of the plurality of upper source/drain areas; and a first vertical conductive rail electrically connected to a first contact of the plurality of lower contacts and the plurality of upper contacts, the first vertical conductive rail extending in the vertical direction, and including a first portion having a first upper surface at a first vertical level and a second portion having a second upper surface at a second vertical level lower than the first vertical level. The second portion overlaps a first upper contact among the plurality of upper contacts in the vertical direction.

According to another aspect of an embodiment, an integrated circuit device including: a plurality of lower transistors, each of which includes: a lower source/drain area; a plurality of lower nanosheets connected to the lower source/drain area and spaced apart from each other in a vertical direction; a lower gate line surrounding the plurality of lower nanosheets and extending in a first direction; and a lower contact on a bottom surface of the lower source/drain area; a plurality of upper transistors, each of which includes: an upper source/drain area spaced apart from the lower source/drain area in the vertical direction; a plurality of upper nanosheets connected to the upper source/drain area and spaced apart from each other in the vertical direction; an upper gate line surrounding the plurality of upper nanosheets and extending in the first direction; and an upper contact on an upper surface of the upper source/drain area; and a plurality of vertical conductive rails electrically connected to the plurality of lower transistors and the plurality of upper transistors, and extending in the vertical direction, a first vertical conductive rail among the plurality of vertical conductive rails including: a first portion having a first upper surface at a first vertical level; and a second portion having a second upper surface at a second vertical level lower than the first vertical level along the vertical direction.

According to another aspect of an embodiment, an integrated circuit device includes: a plurality of lower source/drain areas; a plurality of lower contacts respectively on bottom surfaces of the plurality of lower source/drain areas; a plurality of lower nanosheets connected to each of the plurality of lower source/drain areas and spaced apart from each other in a vertical direction; a lower gate line surrounding the plurality of lower nanosheets and extending in a first direction; an insulating structure on the plurality of lower source/drain areas and the lower gate line; a plurality of upper source/drain areas on the insulating structure; a plurality of upper contacts respectively on upper surfaces of the plurality of upper source/drain areas; a plurality of upper nanosheets connected to each of the plurality of upper source/drain areas and spaced apart from each other in the vertical direction; an upper gate line surrounding the plurality of upper nanosheets and extending in the first direction; and a plurality of vertical conductive rails extending in the vertical direction through the insulating structure and electrically connected to the plurality of lower contacts and the plurality of upper contacts. A first vertical conductive rail among the plurality of vertical conductive rails includes a first portion having a first upper surface at a first vertical level and a second portion having a second upper surface at a second vertical level lower than the first vertical level along the vertical direction.

At least some of the above and other features of the invention are set out in the claims.

### BRIEF DESCRIPTION OF DRAWINGS

The above and other aspects and features will be more apparent from the following description of example embodiments, taken in conjunction with the accompanying drawings, in which:
FIG. 1 is a schematic layout diagram illustrating an integrated circuit device according to embodiments;
FIG. 2 is a cross-sectional view taken along line A1-A1' of FIG. 1;
FIG. 3 is a cross-sectional view taken along the line A2-A2' of FIG. 1;
FIG. 4 is a cross-sectional view taken along line B1-B1' of FIG. 1;
FIG. 5 is a cross-sectional view taken along line B2-B2' of FIG. 1;
FIG. 6 is a perspective view schematically illustrating a first vertical conductive rail of FIG. 1;
FIG. 7 is a perspective view illustrating an integrated circuit device according to embodiments;
FIG. 8 is a perspective view illustrating an integrated circuit device according to embodiments;
FIGS. 9 and 10 are cross-sectional views illustrating an integrated circuit device according to embodiments;
FIG. 11 is a perspective view illustrating an integrated circuit device according to embodiments;
FIG. 12 is a perspective view illustrating an integrated circuit device according to embodiments; and
FIGS. 13, 14, 15A, 15B, 16A, 16B, 16C, 17A, 17B, 18 to 20, 21A, 21B, 22, 23, 24A, 24B, 25, 26A, 26B, 27, 28A, and 28B are cross-sectional views illustrating a method of manufacturing an integrated circuit device, according to embodiments.

### DETAILED DESCRIPTION

Hereinafter, embodiments will be described in detail with reference to the accompanying drawings. Embodiments described herein are example embodiments, and thus, the present disclosure is not limited thereto, and may be realized in various other forms. Each example embodiment provided in the following description is not excluded from being associated with one or more features of another example or another embodiment also provided herein or not provided herein but consistent with the present disclosure. It will be understood that when an element or layer is referred to as being "on," "connected to" or "coupled to" another element or layer, it can be directly on, connected or coupled to the other element or layer, or intervening elements or layers may be present. By contrast, when an element is referred to as being "directly on," "directly connected to" or "directly coupled to" another element or layer, there are no intervening elements or layers present. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c. It will be also understood that, even if a certain step or operation of manufacturing an apparatus or structure is described later than another step or operation, the step or operation may be performed later than the other step or operation unless the other step or operation is described as being performed after the step or operation.

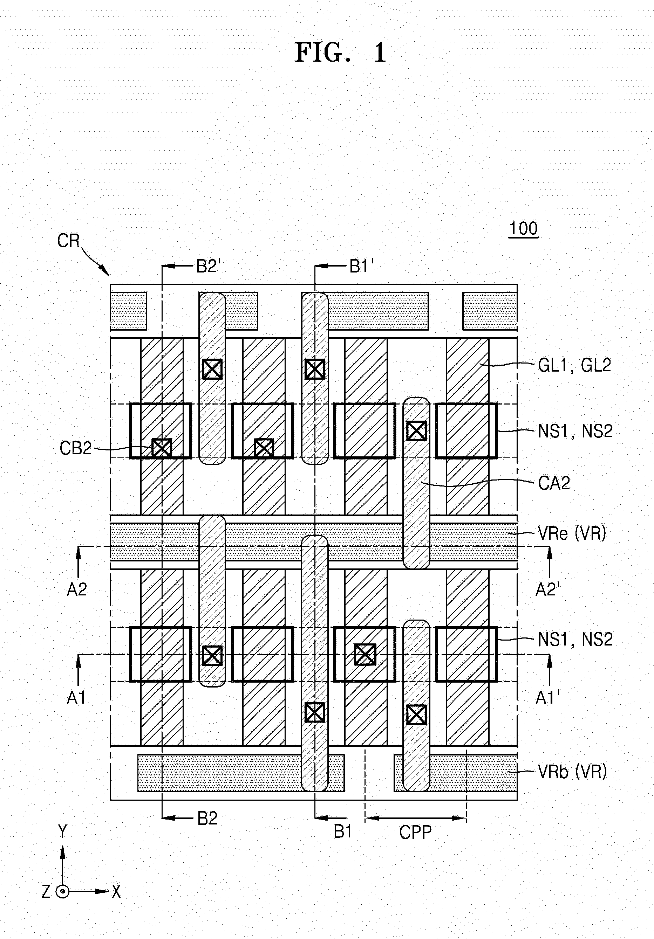

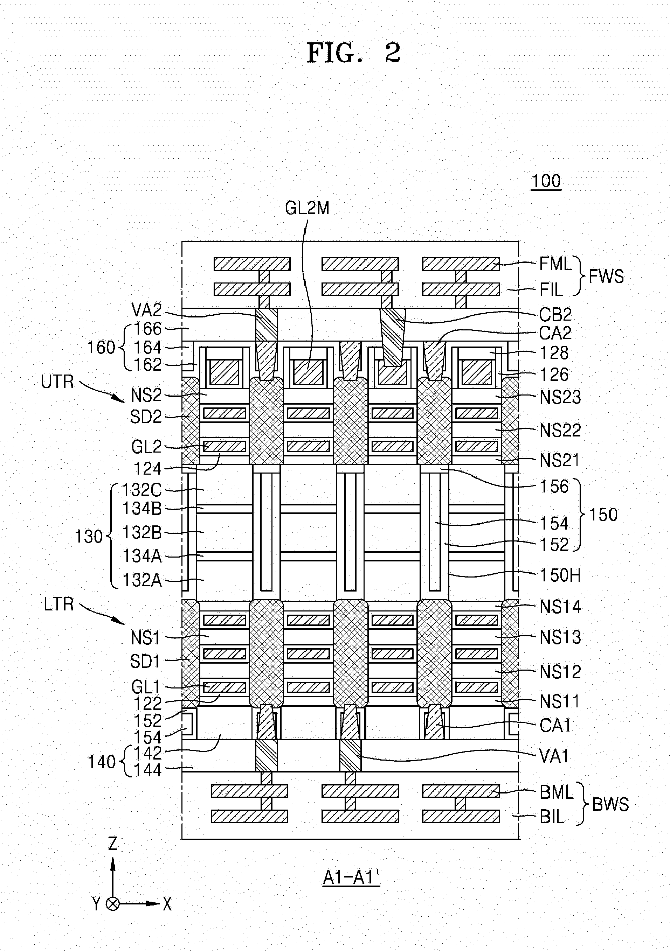

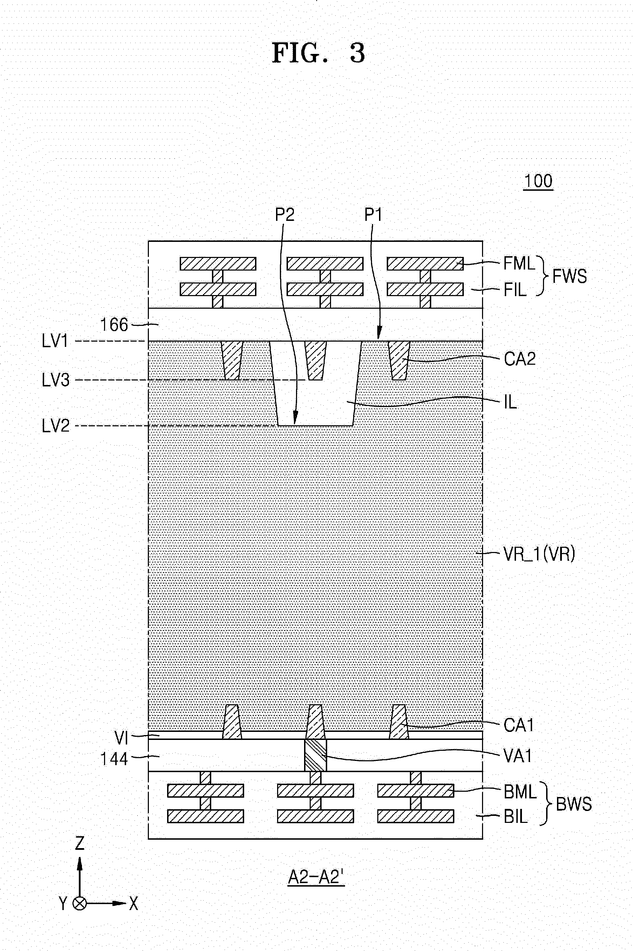

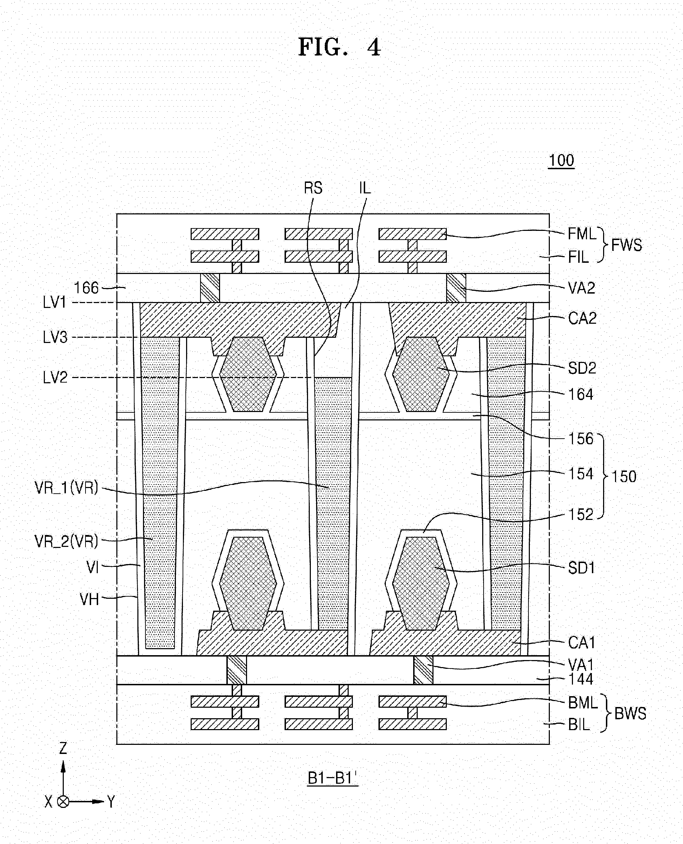

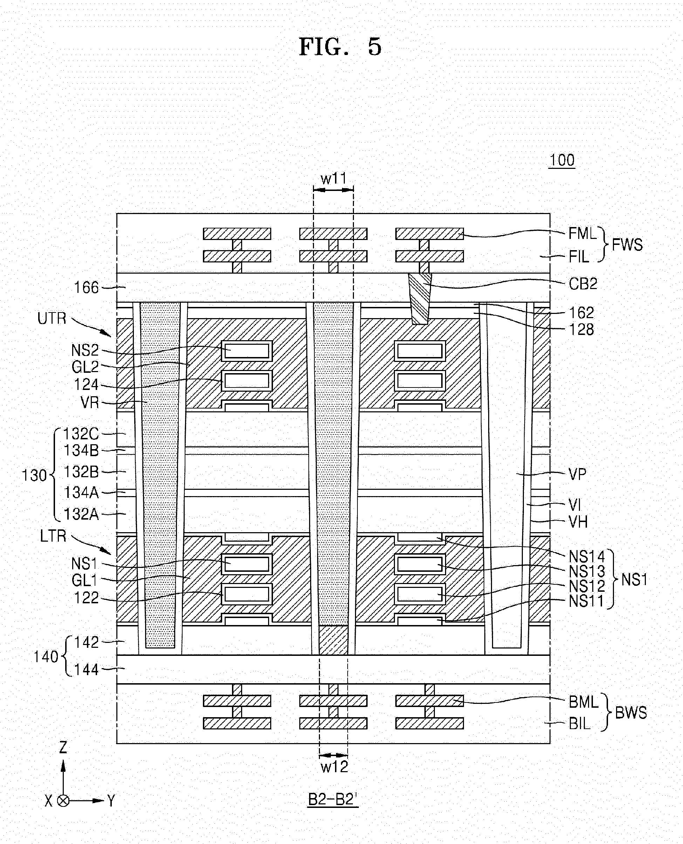

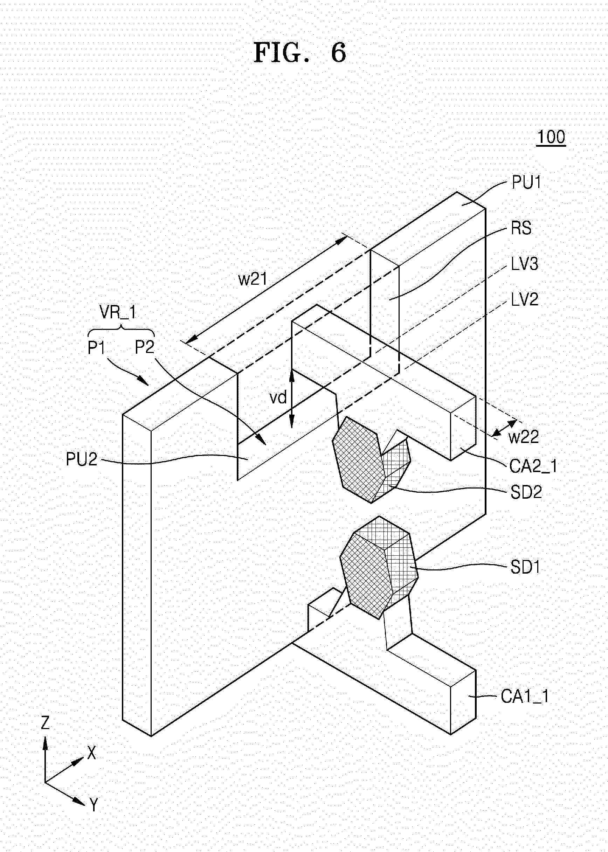

FIG. 1 is a schematic layout diagram illustrating an integrated circuit device 100 according to embodiments. FIG. 2 is a cross-sectional view taken along line A1-A1' of FIG. 1, FIG. 3 is a cross-sectional view taken along the line A2-A2' of FIG. 1, FIG. 4 is a cross-sectional view taken along line B 1-B 1' of FIG. 1, and FIG. 5 is a cross-sectional view taken along line B2-B2' of FIG. 1. FIG. 6 is a perspective view schematically illustrating a first vertical conductive rail VR_1.

Referring to FIGS. 1 to 6, an integrated circuit device 100 may include a plurality of cells CR, and each cell CR may include a plurality of lower transistor LTR and a plurality of upper transistors UTR arranged at different vertical levels in a vertical direction Z. For example, the plurality of upper transistors UTR may be arranged at a higher vertical level than the plurality of lower transistors LTR. Each of the plurality of cells CR may be an area in which various types of logic cells included in a logic circuit are arranged.

The integrated circuit device 100 may further include a front line structure FWS arranged at a higher vertical level than the plurality of upper transistors UTR and a back line structure BWS arranged at a lower vertical level than the plurality of lower transistors LTR. In embodiments, the front line structure FWS may be configured to provide a signal voltage to the plurality of lower transistors LTR and the plurality of upper transistors UTR, and the back line structure BWS may be configured to provide a power voltage and a ground voltage to the plurality of lower transistors LTR and the plurality of upper transistors UTR.

As illustrated in FIGS. 1 to 6, the integrated circuit device 100 may include a logic cell including a multi-bridge channel FET (MBCFET) device. However, embodiments are not limited thereto, and the integrated circuit device 100 may include a planar FET device, a gate-all-around type FET device, and a finFET device, a FET device based on a two-dimensional material, such as a (Molybdenum Sulphide) MoS₂ semiconductor gate electrode, or the like.

Each of the plurality of lower transistors LTR may include a plurality of lower nanosheets NS1 spaced apart from each other in the vertical direction Z, a lower source/drain area SD1 connected to the plurality of lower nanosheets NS 1, a lower gate line GL1 surrounding the plurality of lower nanosheets NS1, and a lower contact CA1 arranged on a bottom surface of the lower source/drain area SD1.

Each of the plurality of upper transistors UTR may include a plurality of upper nanosheets NS2 spaced apart from each other in the vertical direction Z, an upper source/drain area SD2 connected to the plurality of upper nanosheets NS2, an upper gate line GL2 surrounding the plurality of upper nanosheets NS2, and an upper contact CA2 arranged on an upper surface of the upper source/drain area SD2.

In embodiments, the plurality of lower transistors LTR may be p-channel metal oxide semiconductor (PMOS) transistors, and the plurality of upper transistors UTR may be n-channel metal oxide semiconductor (NMOS) transistors. In some embodiments, the plurality of lower transistors LTR may be NMOS transistors, and the plurality of upper transistors UTR may be PMOS transistors. In some embodiments, the plurality of lower transistors LTR may be NMOS transistors having a first threshold voltage, and the plurality of upper transistors UTR may be NMOS transistors having a second threshold voltage different from the first threshold voltage. In some embodiments, the plurality of lower transistors LTR may be PMOS transistors having a first threshold voltage, and the plurality of upper transistors UTR may be PMOS transistors having a second threshold voltage different from the first threshold voltage.

Each of the plurality of lower nanosheets NS1 and the plurality of upper nanosheets NS2 may include a group IV semiconductor such as Si or Ge, a group IV-IV compound semiconductor such as SiGe or SiC, or a III-V group compound semiconductor such as GaAs, InAs, or InP. The plurality of lower nanosheets NS1 may include first to fourth lower nanosheets NS11, NS12, NS13, and NS14 spaced apart from each other in the vertical direction Z. The plurality of upper nanosheets NS2 may include first to third upper nanosheets NS21, NS22, and NS23 spaced apart from each other in the vertical direction Z.

The lower source/drain area SD1 may be connected to both ends of the plurality of lower nanosheets NS1. The lower source/drain area SD1 may have an upper surface arranged at a higher level than the uppermost lower nanosheet NS1 (e.g., the fourth lower nanosheet NS14) and may have a bottom surface arranged at a lower level than the lowermost lower nanosheet NS1 (e.g., the first lower nanosheet NS11). In embodiments, the lower source/drain area SD1 may include a doped SiGe layer, a doped Ge layer, a doped SiC layer, or a doped InGaAs layer; however, embodiments are not limited thereto.

The lower gate line GL1 may extend in a second horizontal direction Y to surround the plurality of lower nanosheets NS1 and may be spaced apart from each other at first gate intervals CPP in a first horizontal direction X. A lower gate insulating layer 122 may be arranged between each of the plurality of lower nanosheets NS1 and the lower gate line GL1, and between the lower source/drain area SD1 and the lower gate line GL1. As illustrated in FIGS. 2 and 5, the bottom surface and sidewall of the fourth lower nanosheet NS14 may be surrounded by the lower gate insulating layer 122 and the lower gate line GL1, and the upper surface of the fourth lower nanosheet NS14 may be not surrounded by the lower gate insulating layer 122 and the lower gate line GL1. Also, the upper surface and sidewall of the first lower nanosheet NS11 may be surrounded by the lower gate insulating layer 122 and the lower gate line GL1, and the bottom surface of the first lower nanosheet NS11 may be not surrounded by the lower gate insulating layer 122 and the lower gate line GL1.

The upper source/drain area SD2 may be connected to both ends of the plurality of upper nanosheets NS2. The upper source/drain area SD2 may be spaced apart from the lower source/drain area SD1 in the vertical direction Z at a position of vertically overlapping the lower source/drain area SD1. The upper source/drain area SD2 may have an upper surface arranged at a higher level than the uppermost upper nanosheet NS2 (e.g., the third upper nanosheet NS23) and may have a bottom surface arranged at a lower level than the lowermost upper nanosheet NS2 (e.g., the first upper nanosheet NS21). In embodiments, the upper source/drain area SD2 may include a doped SiGe layer, a doped Ge layer, a doped SiC layer, or a doped InGaAs layer; however, embodiments are not limited thereto.

The upper gate line GL2 may extend in the second horizontal direction Y to surround the plurality of upper nanosheets NS2 and may be spaced apart from each other at the first gate intervals CPP in the first horizontal direction X. The upper gate line GL2 may be arranged at a position of vertically overlapping the lower gate line GL1. An upper gate insulating layer 124 may be arranged between each of the plurality of upper nanosheets NS2 and the upper gate line GL2, and between the upper source/drain area SD2 and the upper gate line GL2.

As illustrated in FIG. 2, the upper gate line GL2 may include a main gate portion GL2M arranged on the upper surface of the third upper nanosheet NS23. A spacer 126 may be arranged on both sidewalls of the main gate portion GL2M, and a gate capping layer 128 may be arranged on the upper surface of the main gate portion GL2M. The upper gate insulating layer 124 may be arranged between the bottom surface of the main gate portion GL2M and the third upper nanosheet NS23, and may extend in the vertical direction Z between the sidewall of the main gate portion GL2M and the spacer 126. The upper surface and sidewall of the first upper nanosheet NS21 may be surrounded by the upper gate insulating layer 124 and the upper gate line GL2, and the bottom surface of the first upper nanosheet NS21 may not be surrounded by the upper gate insulating layer 124 and the upper gate line GL2.

In embodiments, the lower gate line GL1 and the upper gate line GL2 may include doped polysilicon, metal, conductive metal nitride, conductive metal carbide, conductive metal silicide, or any combination thereof; for example, the lower gate line GL1 and the upper gate line GL2 may include Al, Cu, Ti, Ta, W, Mo, TaN, NiSi, CoSi, TiN, WN, TiAl, TiAlN, TaCN, TaC, TaSiN, or any combination thereof; however, embodiments are not limited thereto. In embodiments, the lower gate line GL1 and the upper gate line GL2 may include a work function metal-containing layer and a gap-fill metal layer. The work function metal-containing layer may include at least one metal among Ti, W, Ru, Nb, Mo, Hf, Ni, Co, Pt, Yb, Tb, Dy, Er, and Pd. The gap-fill metal layer may include a W layer or an Al layer. In embodiments, the lower gate line GL1 and the upper gate line GL2 may have a TiAlC/TiN/W stack structure, a TiN/TaN/TiAlC/TiN/W stack structure, or a TiN/TaN/TiN/W stack structure; however, embodiments are not limited thereto.

In embodiments, the lower gate insulating layer 122 and the upper gate insulating layer 124 may include a silicon oxide layer, a silicon oxynitride layer, a high-k dielectric layer having a higher dielectric constant than the silicon oxide layer, or any combination thereof. The high-k dielectric layer may include metal oxide or metal oxynitride. For example, the high-k dielectric layer usable as the lower gate insulating layer 122 and the upper gate insulating layer 124 may include HfO₂, HfSiO, HfSiON, HfTaO, HfTiO, HfZrO, ZrO₂, Al₂O₃, or any combination thereof; however, embodiments are not limited thereto.

In embodiments, the spacer 126 may include silicon oxide (SiOₓ), silicon nitride (SiNₓ), silicon oxynitride (SiOₓN_{y}), silicon carbonitride (SiCₓN_{y}), silicon oxycarbonitride (SiOₓC_{y}N_{z}), or any combination thereof. In embodiments, the gate capping layer 128 may include silicon nitride or silicon oxynitride.

The lower contact CA1 may be arranged on the bottom surface of the lower source/drain area SD1 (e.g., under the lower source/drain area SD1 or at a lower vertical level than the lower source/drain area SD1 as illustrated in FIG. 2). The upper contact CA2 may be arranged on the upper surface of the upper source/drain area SD2 (e.g., at a higher vertical level than the upper source/drain area SD2 as illustrated in FIG. 2). In embodiments, the lower contact CA1 and the upper contact CA2 may include at least one of tungsten (W), cobalt (Co), molybdenum (Mo), nickel (Ni), ruthenium (Ru), copper (Cu), aluminum (Al), titanium (Ti), titanium nitride (TiN), tantalum (Ta), tantalum nitride (TaN), titanium silicon nitride (TiSiN), titanium silicide (TiSi), and tungsten silicide (WSi).

An insulating structure 130 may be arranged between the lower transistor LTR and the upper transistor UTR. The bottom surface of the lowermost upper nanosheet NS2 (e.g., the first upper nanosheet NS21) and the bottom surface of the upper source/drain area SD2 may be arranged on the upper surface of the insulating structure 130. The upper surface of the uppermost lower nanosheet NS1 (e.g., the fourth lower nanosheet NS 14) and the upper surface of the lower source/drain area SD1 may be arranged under the bottom surface of the insulating structure 130 (e.g., at a lower vertical level than the bottom surface of the insulating structure 130).

In embodiments, the insulating structure 130 may include first to third base insulating layers 132A, 132B, and 132C spaced apart from each other in the vertical direction Z, a first intermediate layer 134A arranged between the first and second base insulating layers 132A and 132B, and a second intermediate layer 134B arranged between the second and third base insulating layers 132B and 132C.

The vertical conductive rail VR may extend in the first horizontal direction X and the vertical direction Z between two lower transistors LTR arranged adjacent to each other in the second horizontal direction Y and between two upper transistors UTR arranged adjacent to each other in the second horizontal direction Y. The vertical conductive rail VR may be arranged in a vertical via trench VH extending in the first horizontal direction X and the vertical direction Z.

In embodiments, as illustrated in FIG. 1, the vertical conductive rail VR may include a line-type conductive rail VRe and a bar-type conductive rail VRb. For example, the line-type conductive rail VRe may extend in the first horizontal direction X with a length greater than the width of each cell CR in the first horizontal direction X. The bar-type conductive rail VRb may extend in the first horizontal direction X with a length smaller than the width of each cell CR in the first horizontal direction X. For example, a plurality of bar-type conductive rails VRb may be arranged in a straight line along the first horizontal direction X and spaced apart from each other in the first horizontal direction X. For example, in each cell CR, 2 to 10 bar-type conductive rails VRb may be arranged along the first horizontal direction X and spaced apart from each other in the first horizontal direction X.

A vertical insulating pillar VP may be arranged between two adjacent bar-type conductive rails VRb. In this regard, the vertical insulating pillar VP may be provided between the two adjacent bar-type conductive rails VRb, along the first horizontal direction X. The vertical insulating pillars VP may include an insulating material such as silicon oxide, silicon nitride, or silicon oxynitride.

In embodiments, the vertical conductive rail VR may be a line structure for transmitting a signal voltage, a power voltage, a ground voltage, or the like from the front line structure FWS and the back line structure BWS to the lower transistor LTR and the upper transistor UTR. In some examples, the line-type conductive rail VRe may be configured to provide a power voltage, a ground voltage, or the like from the back line structure BWS to the lower transistor LTR and the upper transistor UTR, and the bar-type conductive rail VRb may be configured to provide a signal voltage from the front line structure FWS to the lower transistor LTR and the upper transistor UTR.

An insulating liner VI may be arranged on both sidewalls of the vertical conductive rail VR. The insulating liner VI may be conformally arranged on the inner wall of the vertical via trench VH, and the vertical conductive rail VR may fill the inside of the vertical via trench VH on the insulating liner VI. For example, the insulating liner VI may cover the bottom surface of a portion of the vertical conductive rail VR. The insulating liner VI may be arranged between the lower side of the sidewall of the vertical conductive rail VR and the lower gate line GL1 arranged adjacent thereto, and between the upper side of the sidewall of the vertical conductive rail VR and the upper gate line GL2 arranged adjacent thereto, and may insulate the vertical conductive rail VR from the lower gate line GL1 and the upper gate line GL2.

In embodiments, the vertical via trench VH may have an inclined sidewall such that an upper width thereof is greater than a bottom width thereof, and the vertical conductive rail VR arranged in the vertical via trench VH may also have an inclined sidewall such that an upper width thereof is greater than a bottom width thereof. For example, as illustrated in FIG. 5, the vertical conductive rail VR may have a first width w11 at the upper side thereof and may have a second width w12 smaller than the first width w11 at the bottom portion thereof.

In embodiments, the vertical conductive rail VR may include a first vertical conductive rail VR_1 and a second vertical conductive rail VR_2. As described with reference to FIG. 6, the first vertical conductive rail VR_1 may have a shape in which an upper portion of the first vertical conductive rail VR_1 is recessed. The second vertical conductive rail VR_2 may have a flat upper surface shape in which an upper portion thereof is not recessed.

The first vertical conductive rail VR_1 includes a first portion P1 and a second portion P2. The first portion P1 has a first upper surface PU1 (see figure 6) arranged at a first vertical level LV1, and the second portion P2 has a second upper surface PU2 arranged at a second vertical level LV2 lower than the first vertical level LV1. The second portion P2 may correspond to a portion of the first vertical conductive rail VR_1 in which a second upper surface PU2 has been lowered by removing an upper portion of the first vertical conductive rail VR_1 by a recess process.

The second portion P2 of the first vertical conductive rail VR_1 vertically overlaps at least a portion of an upper contact CA2 adjacent thereto (hereinafter referred to as a first upper contact CA2_1), and the first upper contact CA2_1 may be not electrically connected to (e.g., may be electrically insulated from) the first vertical conductive rail VR_1. In embodiments, the second upper surface PU2 of the second portion P2 of the first vertical conductive rail VR_1 may be spaced apart from the bottom surface of the first upper contact CA2_1 in the vertical direction Z. For example, the bottom surface of the first upper contact CA2_1 may be arranged at a third vertical level LV3 higher than the second vertical level LV2. In embodiments, a distance vd between the third vertical level LV3 and the second vertical level LV2 in the vertical direction Z may be 10 nanometers or more. In embodiments, the second upper surface PU2 of the second portion P2 of the first vertical conductive rail VR_1 may be arranged at a level lower than the upper surface of the upper source/drain area SD2.

An isolation insulating layer IL may be arranged over the second portion P2 of the first vertical conductive rail VR_1, and the isolation insulating layer IL may be arranged between the second portion P2 of the first vertical conductive rail VR_1 and the bottom surface of the first upper contact CA2_1.

As illustrated in FIG. 6, the second portion P2 of the first vertical conductive rail VR_1 may have a first width w21 in the first horizontal direction X, and the first upper contact CA2_1 may have a second width w22, smaller than the first width w21, in the first horizontal direction X. For example, the first width w21 may be about 2 times to about 10 times the second width w22. Accordingly, a recess area RS may be defined by the second upper surface PU2 of the second portion P2 and the sidewall of the first portion P1 arranged on both sides thereof, and at least a portion of the first upper contact CA2_1 and the isolation insulating layer IL may be arranged in the recess area RS.

In embodiments, the first vertical conductive rail VR_1 is electrically connected to a lower contact CA1 adjacent to the first vertical conductive rail VR_1 among a plurality of lower contacts CA1 (hereinafter referred to as a first lower contact CA1_1). The first lower contact CA1_1 may contact the bottom surface or sidewall of the first vertical conductive rail VR_1. In this regard, the first vertical conductive rail VR_1 may function as a vertical conductive via for electrically connecting the first lower contact CA1_1 to the front line structure FWS. However, in some embodiments, the first vertical conductive rail VR_1 may function as a vertical conductive via for electrically connecting the first lower contact CA1_1 to the back line structure BWS.

A back insulating structure 140 may be arranged on the bottom surface of the lower source/drain area SD1 and the bottom surface of the lower nanosheet NS1 (under the lower source/drain area SD1 and the lower nanosheet NS1 as illustrated in FIG. 2). The back insulating structure 140 may include a first base insulating layer 142 and a second base insulating layer 144. The first base insulating layer 142 may be arranged on the bottom surface of the lower source/drain area SD1 and the bottom surface of the lower nanosheet NS1. The second base insulating layer 144 may be arranged on the bottom surface of the first base insulating layer 142 (under the first base insulating layer 142 as illustrated in FIG. 2).

An insulating line structure 150 may be arranged in an opening portion 150H extending in the second horizontal direction Y through the insulating structure 130 and the back insulating structure 140. The insulating line structure 150 may include an insulating liner 152 arranged on the inner wall of the opening portion 150H, an insulating buried layer 154 arranged over the insulating liner 152 to fill the inside of the opening portion 150H, and a capping liner 156 covering the upper surface of the insulating buried layer 154. The insulating line structure 150 may cover the lower source/drain area SD1 and the lower contact CA1, and may extend in the second horizontal direction Y. For example, the insulating liner 152 may cover the upper surface and the bottom surface of the lower source/drain area SD1, and the capping liner 156 may be in contact with the bottom surface of the upper source/drain area SD2.

A lower via VA1 may be electrically connected to the lower contact CA1 through the second base insulating layer 144.

A back line structure BWS may be arranged on the bottom surface of the back insulating structure 140 (under the back insulating structure 140 as illustrated in FIG. 2). The back line structure BWS may include a first line BML and a first cover insulating layer BIL. The first line BML may include a plurality of conductive patterns arranged at different vertical levels and a plurality of conductive vias connecting the plurality of conductive patterns to each other, and the first cover insulating layer BIL may include a plurality of insulating layers surrounding the plurality of conductive patterns and the plurality of conductive vias.

An upper insulating structure 160 may be arranged on the upper surface of the upper source/drain area SD2 and the upper gate line GL2. The upper insulating structure 160 may include an etch stop layer 162, a passivation layer 164, and an upper insulating layer 166. The etch stop layer 162 may be conformally arranged on the upper surface of the upper source/drain area SD2, the upper surface of the gate capping layer 128, and the spacer 126, and the passivation layer 164 may fill the space between two adjacent upper gate lines GL2 on the etch stop layer 162. The upper insulating layer 166 may be arranged over the etch stop layer 162 and the passivation layer 164.

An upper via VA2 may be electrically connected to the upper contact CA2 through the upper insulating layer 166. The gate contact CB2 may be connected to the upper surface of the upper gate line GL2 through the upper insulating structure 160.

A front line structure FWS may be arranged on the upper surface of the upper insulating structure 160. The front line structure FWS may include a second line FML and a second cover insulating layer FIL. The second line FML may include a plurality of conductive patterns arranged at different vertical levels and a plurality of conductive vias connecting the plurality of conductive patterns to each other, and the second cover insulating layer FIL may include a plurality of insulating layers surrounding the plurality of conductive patterns and the plurality of conductive vias.

The integrated circuit device 100 according to embodiments may have a three-dimensional field effect transistor structure in which the lower transistor LTR and the upper transistor UTR are spaced apart from each other in the vertical direction Z, and the first vertical conductive rail VR_1 of the vertical conductive rail VR may have a recess area RS at the upper side thereof. The recess area RS of the first vertical conductive rail VR_1 and at least a portion of the first upper contact CA2_1 adjacent thereto may vertically overlap each other, while the first vertical conductive rail VR_1 may be not electrically connected to (e.g., may be electrically insulated from) the first upper contact CA2_1. Accordingly, the area occupied by each cell CR (or the height (or the width in the second horizontal direction Y) of each cell CR) may be reduced. Thus, the integrated circuit device 100 may have a reduced area and may be advantageous for improving the integration degree.

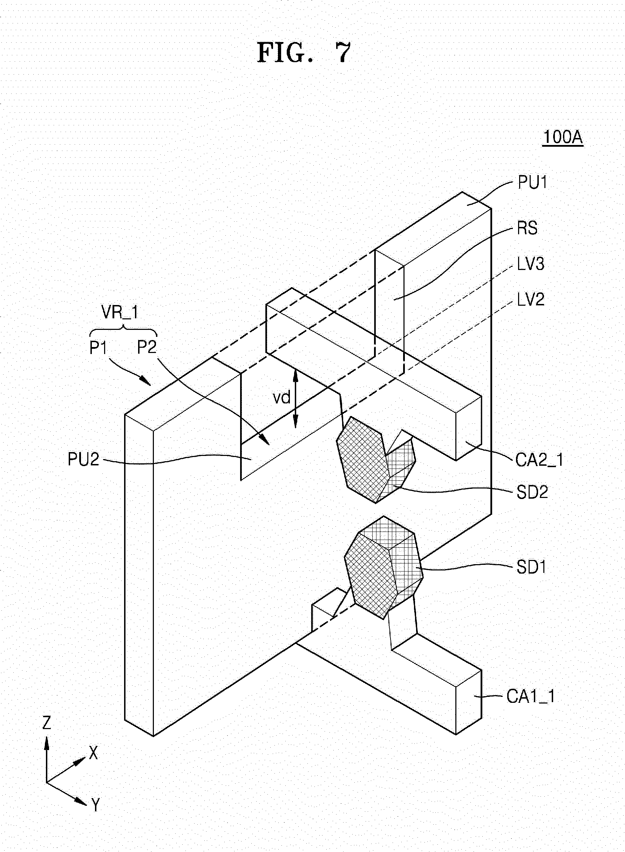

FIG. 7 is a perspective view illustrating an integrated circuit device 100A according to embodiments.

Referring to FIG. 7, the first vertical conductive rail VR_1 vertically overlaps at least a portion of the first upper contact CA2_1 adjacent thereto, and the first upper contact CA2_1 may be placed on (overlap in the z-direction) the second portion P2 over the entire length of the second portion P2 in the second horizontal direction Y.

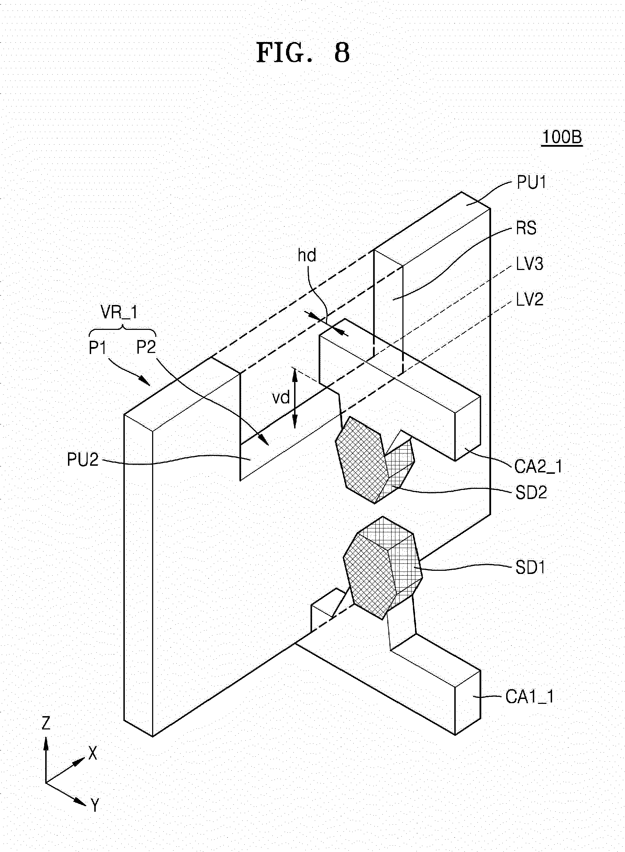

FIG. 8 is a perspective view illustrating an integrated circuit device 100B according to embodiments.

Referring to FIG. 8, the first vertical conductive rail VR_1 may be arranged close to the first upper contact CA2_1 adjacent thereto. The second portion P2 may be spaced apart from the first upper contact CA2_1 by a spacing distance hd in the second horizontal direction Y, and in this regard may be not vertically overlapping with the first upper contact CA2_1. The spacing distance hd may be smaller than a generally adopted minimum spacing distance for forming the first upper contact CA2_1 (or a minimum distance considering a process margin). Accordingly, when the first vertical conductive rail VR_1 and the first upper contact CA2_1 need to be arranged at the spacing distance hd along the second horizontal direction Y smaller than the minimum spacing distance considering the process margin, due to the spacing along the vertical direction Z, the first vertical conductive rail VR_1 and the first upper contact CA2_1 may be arranged not to be electrically connected to each other and the integrated circuit device 100B may have a reduced area and may be advantageous for improving the integration degree.

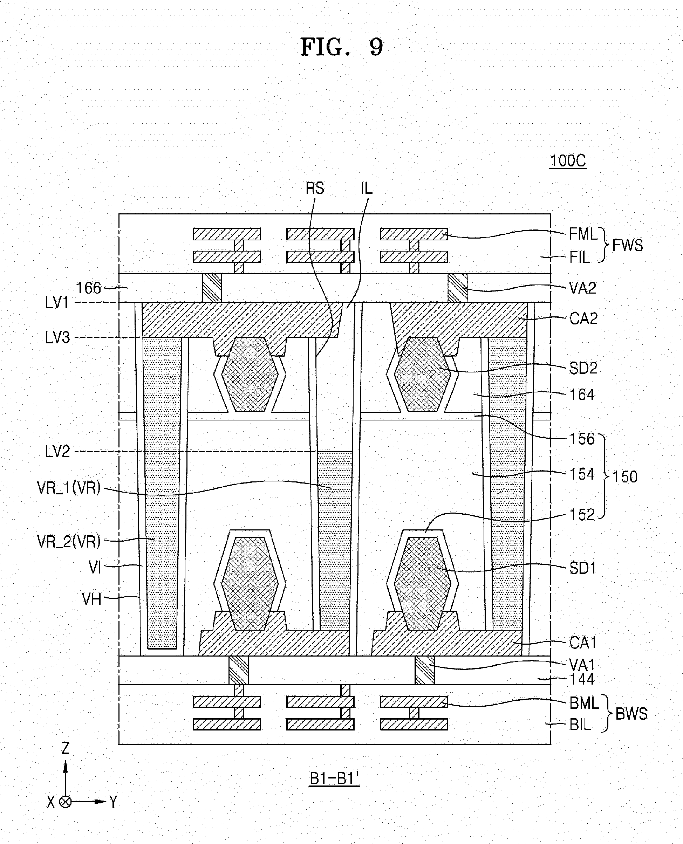

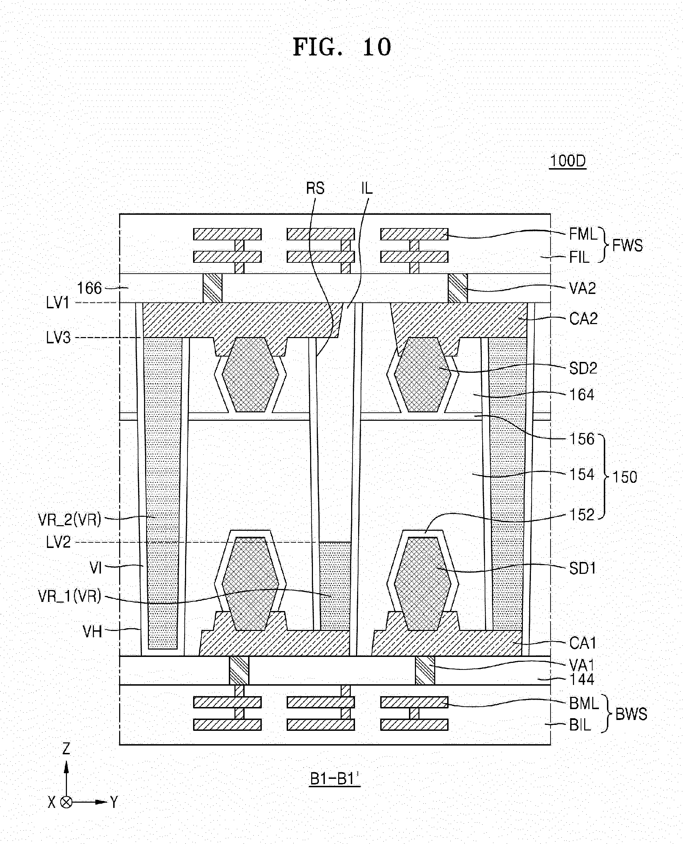

FIGS. 9 and 10 are cross-sectional views illustrating integrated circuit devices 100C and 100D according to embodiments.

Referring to FIG. 9, the second upper surface PU2 of the second portion P2 of the first vertical conductive rail VR_1 may be arranged at a lower level than the bottom surface of the upper contact CA2. For example, the second upper surface PU2 of the second portion P2 of the first vertical conductive rail VR_1 may be arranged at a level lower than the upper surface of the insulating buried layer 154 and higher than the bottom surface of the insulating buried layer 154.

Referring to FIG. 10, the second upper surface PU2 of the second portion P2 of the first vertical conductive rail VR_1 may be arranged at a lower level than the bottom surface of the insulating buried layer 154. For example, the second upper surface PU2 of the second portion P2 of the first vertical conductive rail VR_1 may be arranged at a lower vertical level than the upper surface of the lower source/drain area SD1.

In the embodiments described with reference to FIGS. 9 and 10, because an upper portion of the first vertical conductive rail VR_1 is removed by a recess process and the second upper surface PU2 of the second portion P2 is arranged at a relatively low vertical level, the operation speed of the integrated circuit device 100D may be improved by minimizing the parasitic capacitance between the metal lines.

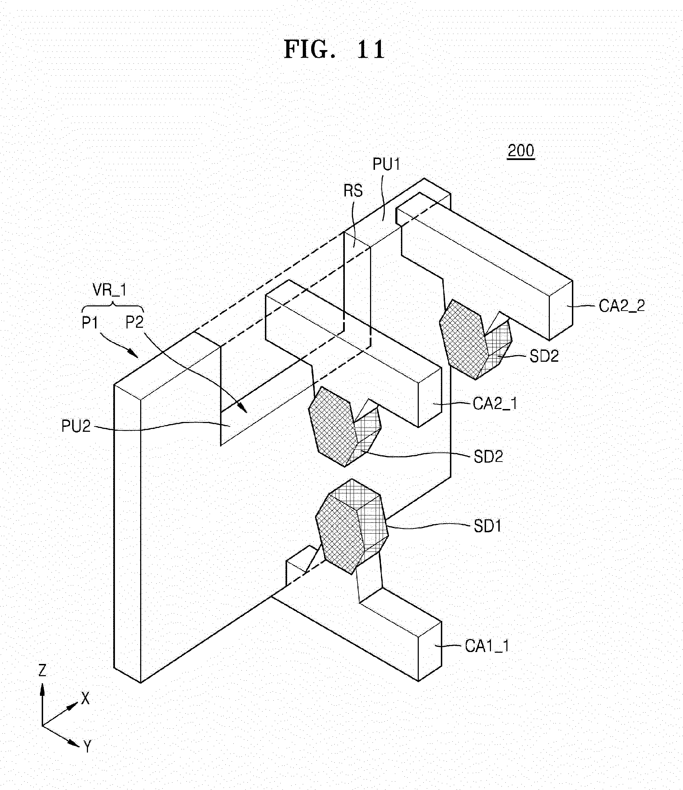

FIG. 11 is a perspective view illustrating an integrated circuit device 200 according to embodiments.

Referring to FIG. 11, the first vertical conductive rail VR_1 is electrically connected to a lower contact CA1 adjacent to the first vertical conductive rail VR_1 among a plurality of lower contacts CA1 (hereinafter referred to as a first lower contact CA1_1) and may also be electrically connected to a second upper contact CA2_2 adjacent to a first upper contact CA2_1 among a plurality of upper contacts CA2. In this regard, the first vertical conductive rail VR_1 may function as a vertical conductive via for electrically connecting the first lower contact CA1_1 to the second upper contact CA2_2. Accordingly, the lower source/drain area SD1 connected to the first lower contact CA1_1 may be electrically connected to the upper source/drain area SD2 connected to the second upper contact CA2_2 spaced apart from the first lower contact CA1_1 in the first horizontal direction X.

The first upper contact CA2_1 may be arranged in the recess area RS of the first vertical conductive rail VR_1 and may be not electrically connected to (e.g., may be electrically insulated from) the first vertical conductive rail VR_1.

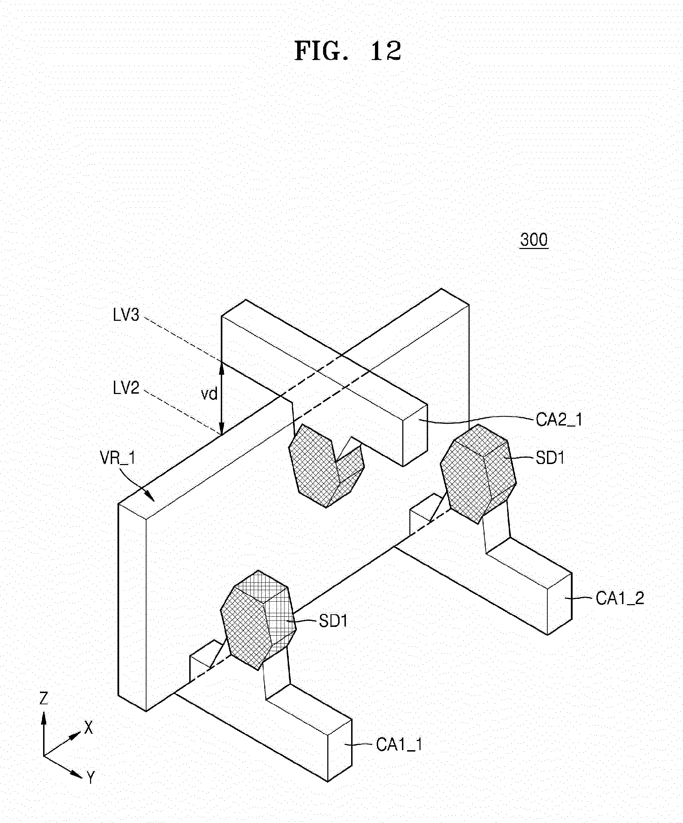

FIG. 12 is a perspective view illustrating an integrated circuit device 300 according to embodiments.

Referring to FIG. 12, the entire upper surface of the first vertical conductive rail VR_1 may have a flat shape and may be arranged at the second vertical level LV2. The first vertical conductive rail VR_1 may vertically overlap at least a portion of the first upper contact CA2_1, and because the upper surface of the first vertical conductive rail VR_1 is arranged at the second vertical level LV2 and the bottom surface of the first upper contact CA2_1 is arranged at the third vertical level LV3 higher than the second vertical level LV2, the first vertical conductive rail VR_1 may not be electrically connected to (e.g., may be electrically insulated from) the first upper contact CA2_1.

The first vertical conductive rail VR_1 may be electrically connected to a lower contact CA1 adjacent to the first vertical conductive rail VR_1 among a plurality of lower contacts CA1 (hereinafter referred to as a first lower contact CA1_1) and may also be electrically connected to a second lower contact CA1_2 spaced apart from the first lower contact CA1_1 in the first horizontal direction X among the plurality of lower contacts CA1. In this regard, the first vertical conductive rail VR_1 may function as a vertical conductive via for electrically connecting the first lower contact CA1_1 to the second lower contact CA1_2. Accordingly, the lower source/drain area SD1 connected to the first lower contact CA1_1 may be electrically connected to the lower source/drain area SD1 connected to the second lower contact CA1_2 spaced apart from the first lower contact CA1_1 in the first horizontal direction X. The vertical conductive rail of figure 12 may be used in devices including the conductive rails or any one of the disclosed embodiments.

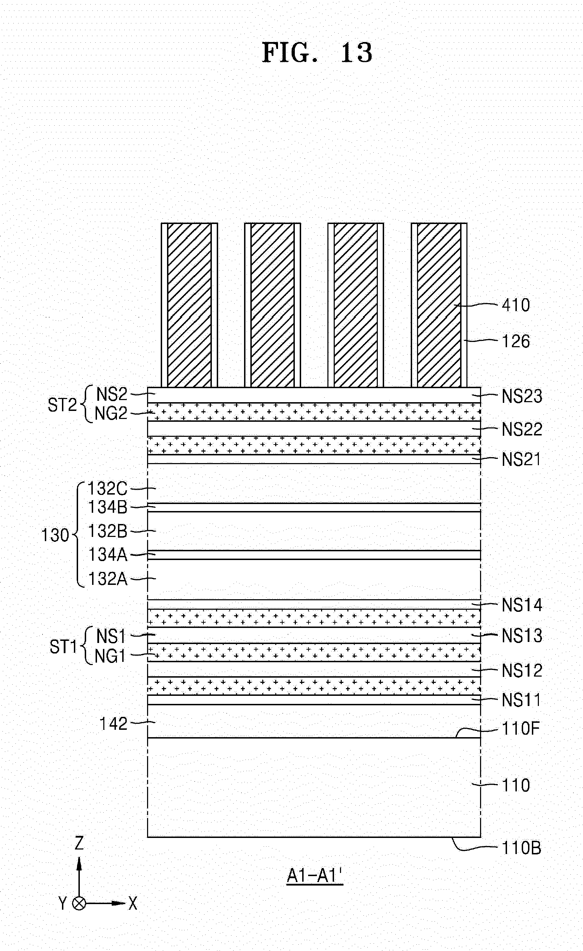

FIGS. 13, 14, 15A, 15B, 16A, 16B, 16C, 17A, 17B, 18 to 20, 21A, 21B, 22, 23, 24A, 24B, 25, 26A, 26B, 27, 28A, and 28B are cross-sectional views illustrating a method of manufacturing an integrated circuit device 100, according to embodiments. Particularly, FIGS. 13, 14, 15A, 16A, 24A, 25, 26A, 27, and 28A are cross-sectional views taken along line A1-A1' of FIG. 1, FIGS. 15B, 16B, 17A, 18, 21A, 22, 23, 24B, 26B, and 28B are cross-sectional views taken along line B1-B1' of FIG. 1, and FIGS. 16C, 17B, 19, 20 and 21B are cross-sectional views taken along line B2-B2' of FIG. 1.

Referring to FIG. 13, a first base insulating layer 142 and a lower channel stack ST1 may be formed over a substrate 110 having a first surface 110F and a second surface 110B. The lower channel stack ST1 may include a plurality of lower nanosheets NS1 and a plurality of lower sacrificial layers NG1 alternately arranged over the first base insulating layer 142.

The plurality of lower nanosheets NS1 may include a group IV semiconductor such as Si or Ge, a group IV-IV compound semiconductor such as SiGe or SiC, or a III-V group compound semiconductor such as GaAs, InAs, or InP. The plurality of lower sacrificial layers NG1 may include a material having an etch selectivity with respect to the plurality of lower nanosheets NS1. In some embodiments, the plurality of lower nanosheets NS1 may include silicon (Si), and the plurality of lower sacrificial layers NG1 may include silicon germanium (SiGe). In embodiments, the plurality of lower nanosheets NS1 and the plurality of lower sacrificial layers NG1 may be formed by an epitaxial growth process, wherein the epitaxial growth process may include vapor-phase epitaxy (VPE), a CVD process such as ultra-high vacuum chemical vapor deposition (UHV-CVD), molecular beam epitaxy, or any combination thereof.

A first base insulating layer 132A, a first intermediate layer 134A, a second base insulating layer 132B, a second intermediate layer 134B, and a third base insulating layer 132C may be sequentially formed over the lower channel stack ST1. The first and second intermediate layers 134A and 134B may include a material having an etch selectivity with respect to the first to third base insulating layers 132A, 132B, and 132C. For example, the first to third base insulating layers 132A, 132B, and 132C may include silicon oxide or a low-k dielectric material, and the first and second intermediate layers 134A and 134B may include silicon nitride, silicon carbide, polysilicon, or the like.

An upper channel stack ST2 may be formed over the third base insulating layer 132C. The upper channel stack ST2 may include a plurality of upper nanosheets NS2 and a plurality of upper sacrificial layers NG2 alternately arranged over the third base insulating layer 132C.

The plurality of upper nanosheets NS2 may include a group IV semiconductor such as Si or Ge, a group IV-IV compound semiconductor such as SiGe or SiC, or a III-V group compound semiconductor such as GaAs, InAs, or InP. The plurality of upper sacrificial layers NG2 may include a material having an etch selectivity with respect to the plurality of upper nanosheets NS2.

A plurality of dummy gate lines 410 extending in the second horizontal direction Y may be formed over the upper channel stack ST2. The plurality of dummy gate lines 410 may be consistently spaced apart from each other at an interval in the first horizontal direction X. In embodiments, the plurality of dummy gate lines 410 may be formed by using at least one of silicon oxide, silicon nitride, polysilicon, and a spin-on hard mask. Each of the plurality of dummy gate lines 410 may have a double layer structure including different materials. A spacer 126 may be formed on the sidewall of the plurality of dummy gate lines 410.

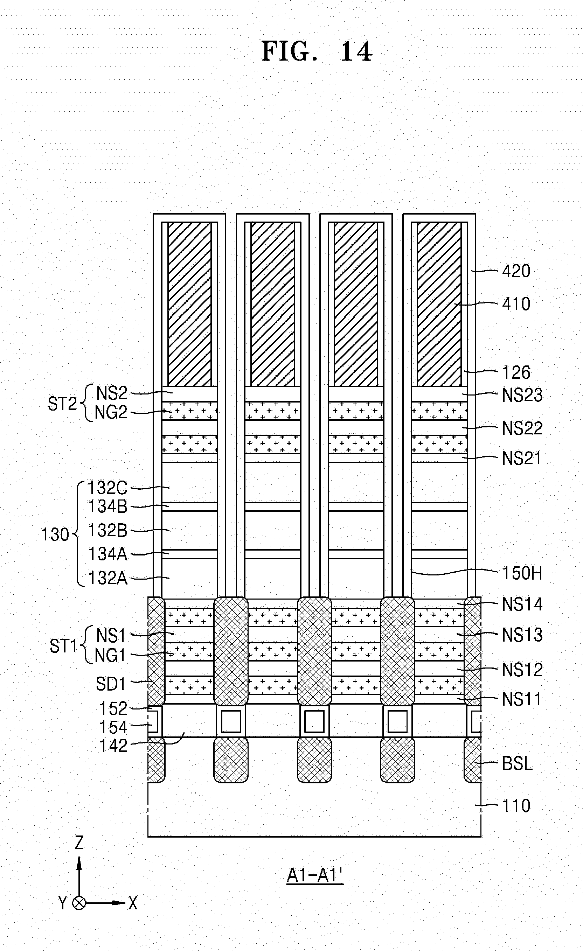

Referring to FIG. 14, an opening portion 150H extending in the second horizontal direction Y may be formed by etching the upper channel stack ST2, the insulating structure 130, the lower channel stack ST1, the first base insulating layer 142, and portions of the substrate 110 by using the plurality of dummy gate lines 410 and the spacer 126 as an etch mask.

A spacer liner 420 may be formed to cover the sidewall of the plurality of dummy gate lines 410 and the sidewall of the upper channel stack ST2. A sacrificial layer BSL may be formed at the bottom portion of the opening portion 150H by performing an epitaxial growth process with the sidewall of the upper channel stack ST2 covered by the spacer liner 420, and a lower source/drain area SD1 may be formed on the sidewall of the lower channel stack ST1.

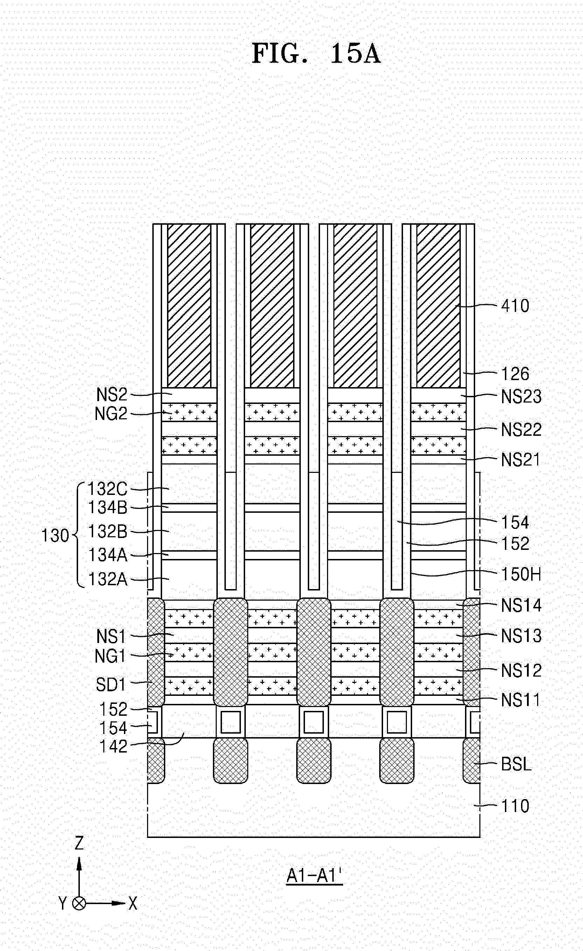

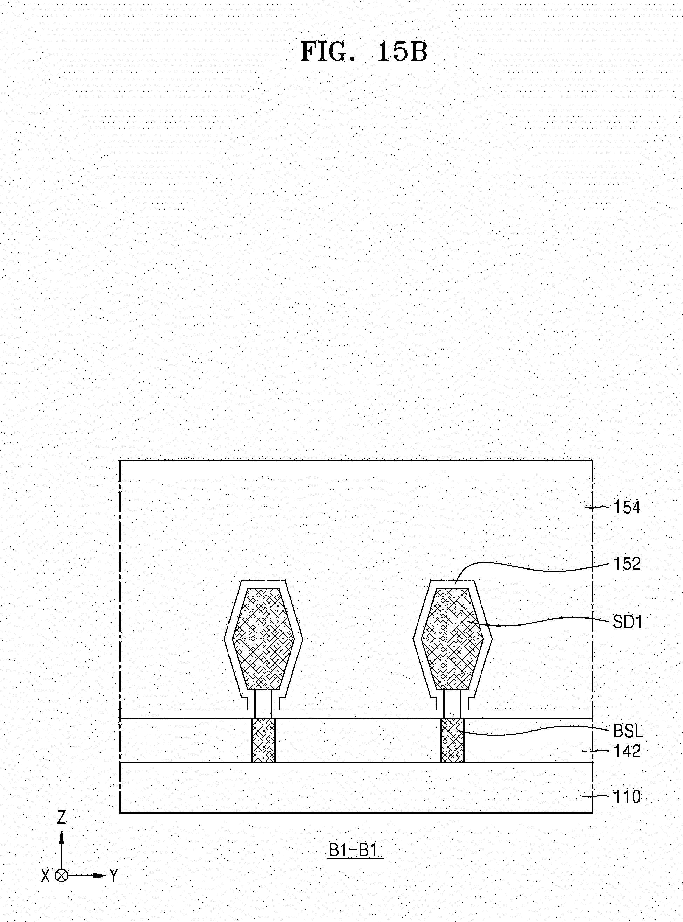

Referring to FIGS. 15A and 15B, an insulating liner 152 may be formed to cover the sidewall of the insulating structure 130, the sidewall of the plurality of dummy gate lines 410, the sidewall of the upper channel stack ST2, and the lower source/drain area SD1.

In some embodiments, the spacer liner 420 may be removed before the forming of the insulating liner 152.

An insulating layer filling the opening portion 150H may be formed, and an insulating buried layer 154 may be formed by removing an upper portion of the insulating layer by a recess process. The recess process may be performed such that the upper surface of the insulating buried layer 154 is arranged at a lower level than the bottom surface of the upper channel stack ST2.

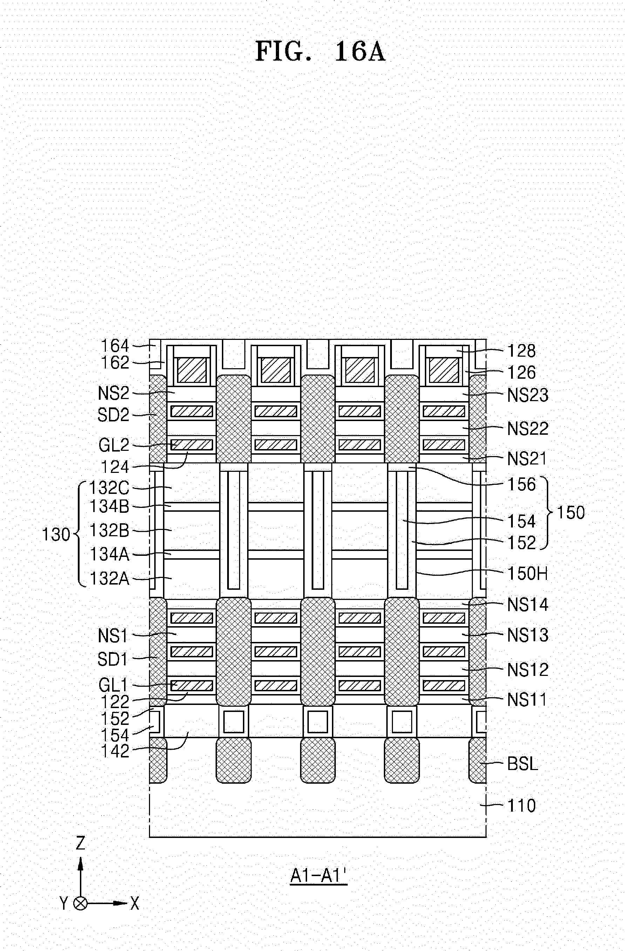

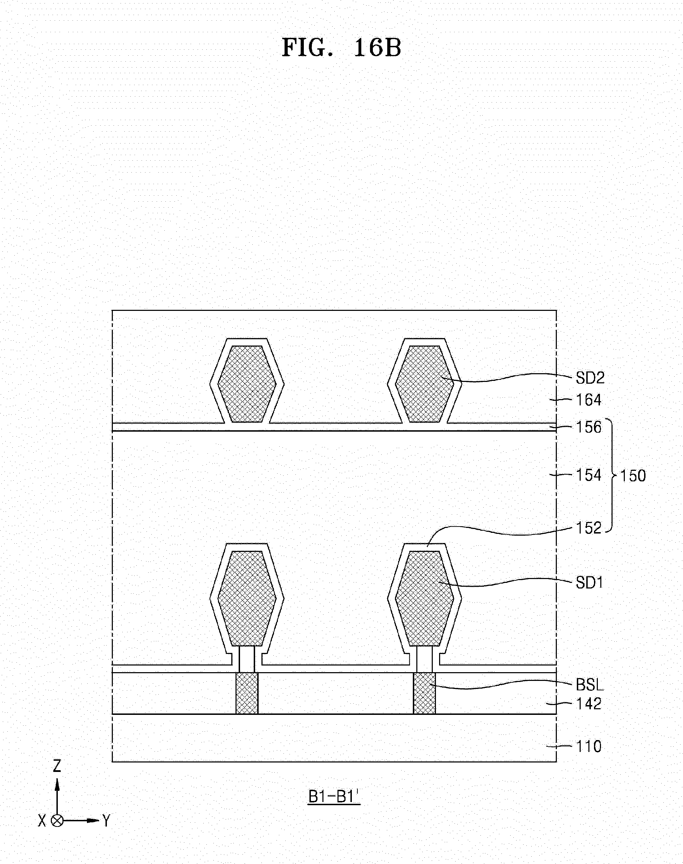

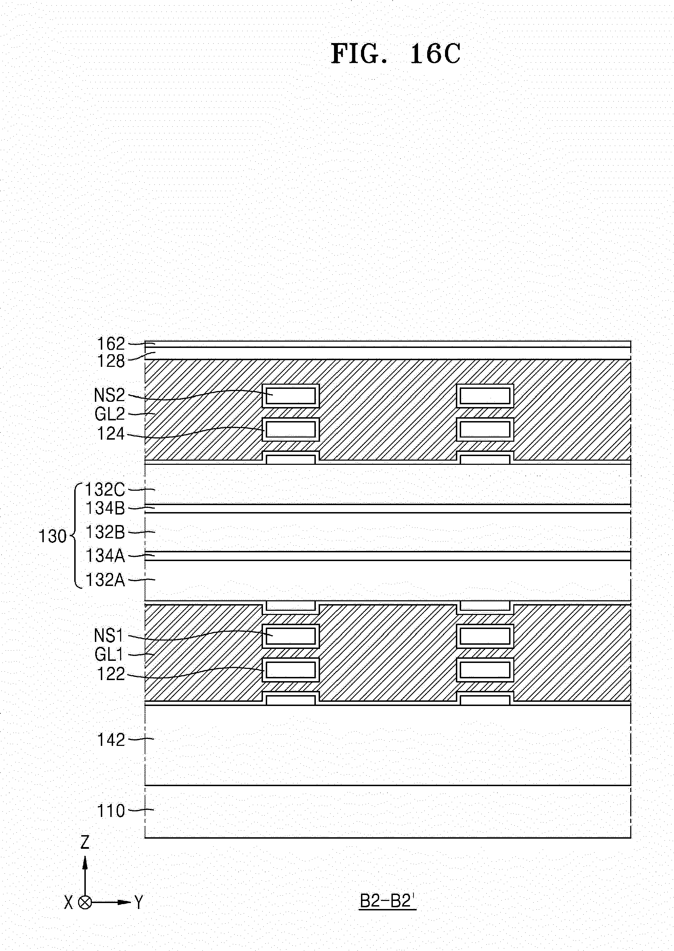

Referring to FIGS. 16A to 16C, an insulating layer may be formed to cover the upper surface of the insulating buried layer 154, and a capping liner 156 completely covering the upper surface of the insulating buried layer 154 may be formed by performing an anisotropic etching process on the insulating layer.

Herein, the insulating liner 152, the insulating buried layer 154, and the capping liner 156 will be referred to as an insulating line structure 150.

The sidewall of the upper channel stack ST2 may be exposed by removing a portion of the insulating liner 152 and the spacer liner 420, and an upper source/drain area SD2 may be formed on the exposed sidewall of the upper channel stack ST2 by an epitaxial growth process.

The dummy gate line 410 may be removed, and the upper channel stack ST2 and the lower channel stack ST1 may be exposed. The surface of each of the plurality of lower nanosheets NS 1 and the plurality of upper nanosheets NS2 may be exposed by removing the plurality of lower sacrificial layers NG1 and the plurality of upper sacrificial layers NG2. The process of removing the plurality of lower sacrificial layers NG1 and the plurality of upper sacrificial layers NG2 may be a wet etching process using an etch selectivity.

A lower gate insulating layer 122 and a lower gate line GL1 may be formed in the space from which the plurality of lower sacrificial layers NG1 have been removed, and an upper gate insulating layer 124 and an upper gate line GL2 may be formed in the space from which the plurality of upper sacrificial layers NG2 have been removed.

In embodiments, the lower gate line GL1 and the upper gate line GL2 may include a work function control layer and a buried conductive layer, and in embodiments, the work function control layer may include Al, Cu, Ti, Ta, W, Mo, TaN, NiSi, CoSi, TiN, WN, TiAl, TiAlC, TiAlN, TaCN, TaC, TaSiN, or any combination thereof. The buried conductive layer may be formed by using Al, Cu, Ti, Ta, W, Mo, TaN, NiSi, CoSi, TiN, WN, TiAl, TiAlC, TiAlN, TaCN, TaC, TaSiN, or any combination thereof.

A gate capping layer 128, an etch stop layer 162, and a passivation layer 164 may be formed over the upper gate line GL2.

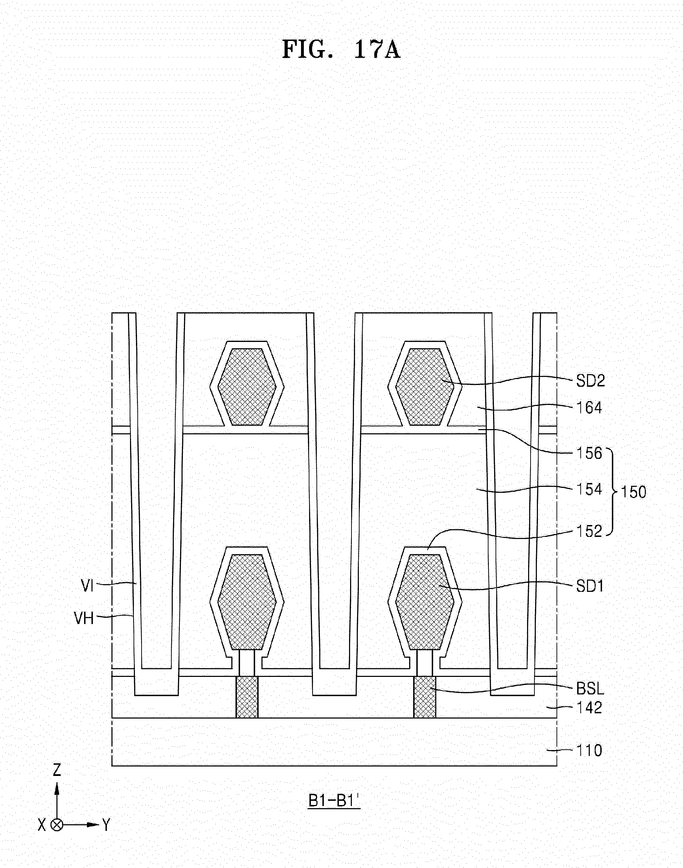

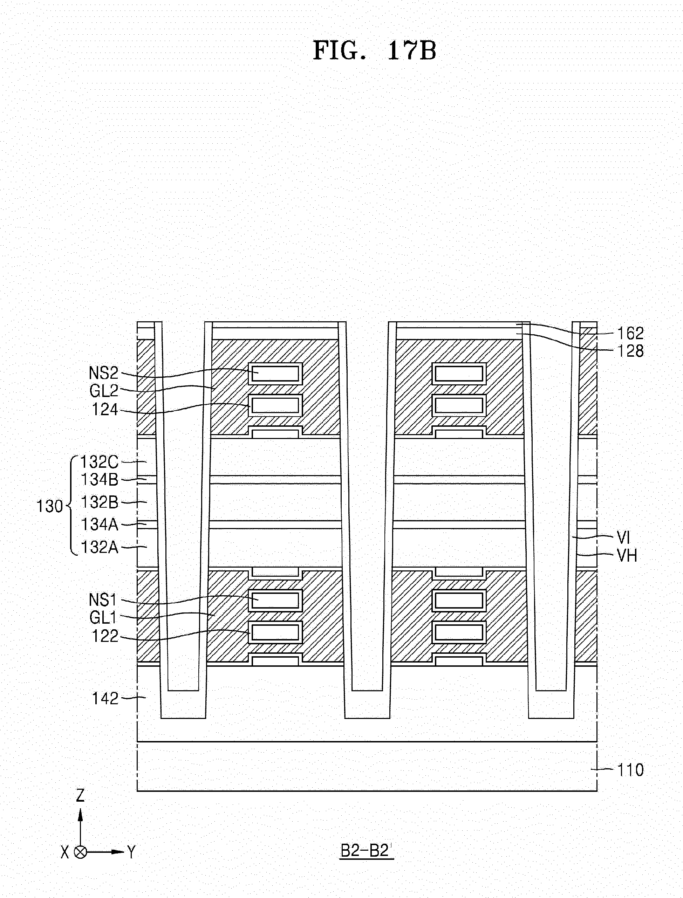

Referring to FIGS. 17A and 17B, a vertical via trench VH extending in the vertical direction Z may be formed through the lower gate line GL1 and the upper gate line GL2. The vertical via trench VH may extend in the first horizontal direction X through the passivation layer 164 and the insulating buried layer 154.

An insulating liner VI may be formed on the inner wall of the vertical via trench VH. The insulating liner VI may be conformally arranged on the sidewall and bottom portion of the vertical via trench VH.

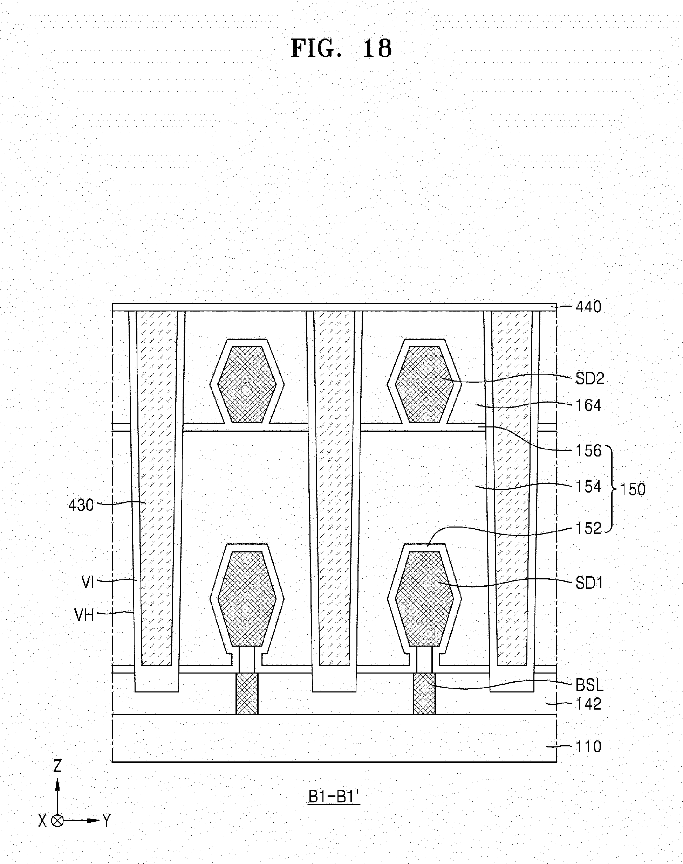

Referring to FIG. 18, a sacrificial line 430 filling the inside of the vertical via trench VH may be formed over the insulating liner VI. In embodiments, the sacrificial line 430 may be formed by using at least one of a spin-on hard mask (SOH), a spin-on insulator (SOD), silicon carbide, and polysilicon. An etch stop layer 440 may be formed to cover the upper surface of the sacrificial line 430.

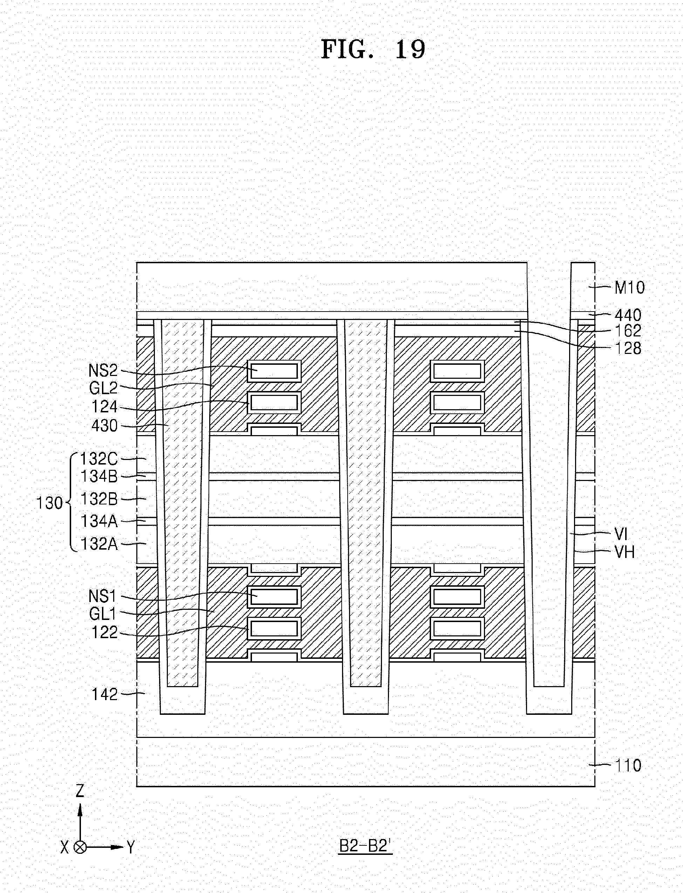

Referring to FIG. 19, a first mask pattern M10 may be formed over the etch stop layer 440, and a portion of the sacrificial line 430 may be removed by using the first mask pattern M10 as an etch mask.

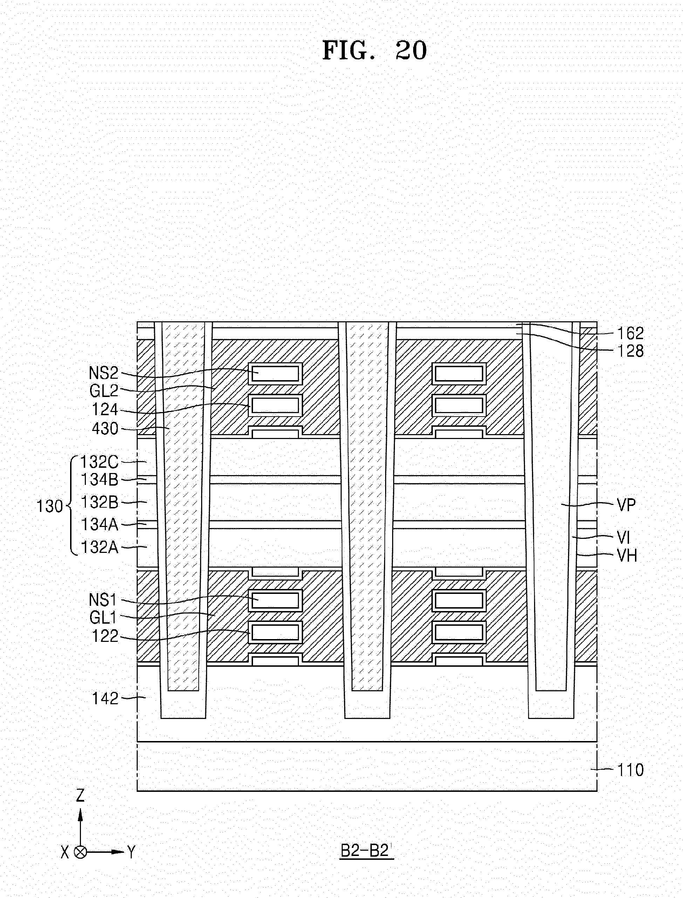

Referring to FIG. 20, an insulating layer may be formed in the vertical via trench VH from which the sacrificial line 430 has been removed, and a vertical insulating pillar VP may be formed in the vertical via trench VH by removing the upper portion of the insulating layer until the upper surface of the etch stop layer 440 is exposed.

The first mask pattern M10 and the etch stop layer 440 may be removed.

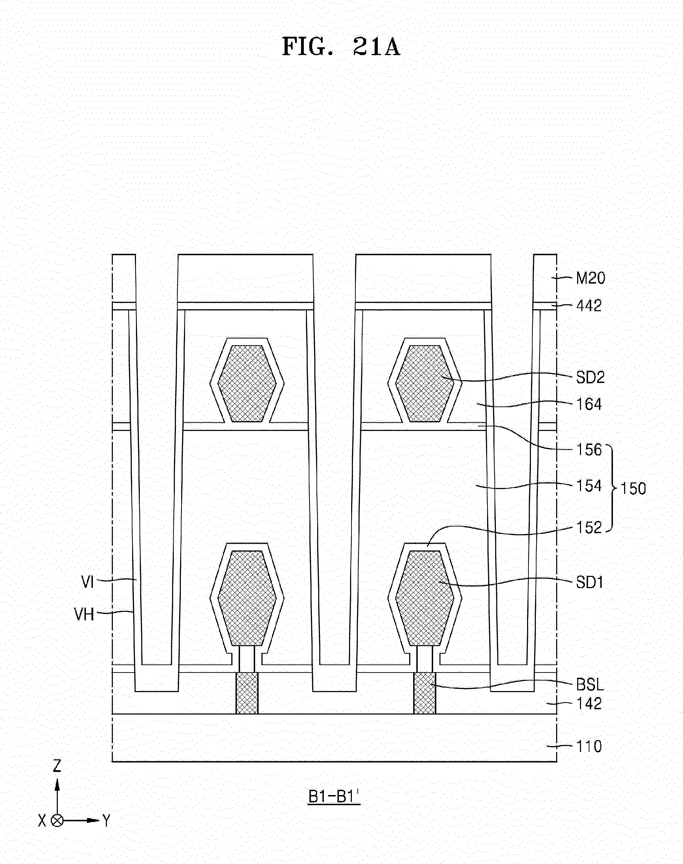

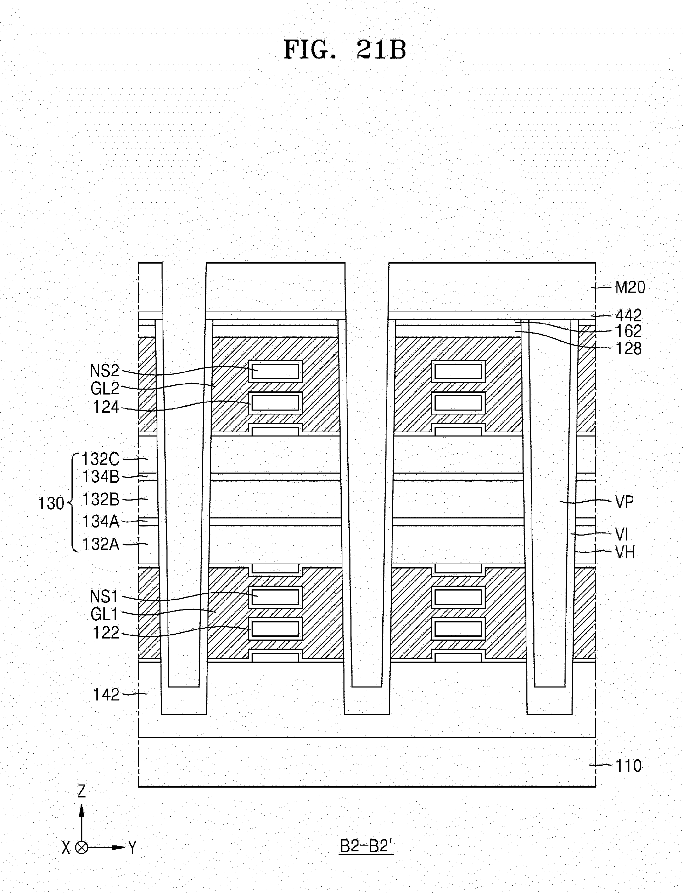

Referring to FIGS. 21A and 21B, an etch stop layer 442 may be formed to cover the upper surface of the vertical insulating pillar VP, the passivation layer 164 and the insulating liner VI. A second mask pattern M20 may be formed over the etch stop layer 442, and the sacrificial line 430 may be removed from one or more of the vertical via trenches VH by using the second mask pattern M20 as an etch mask.

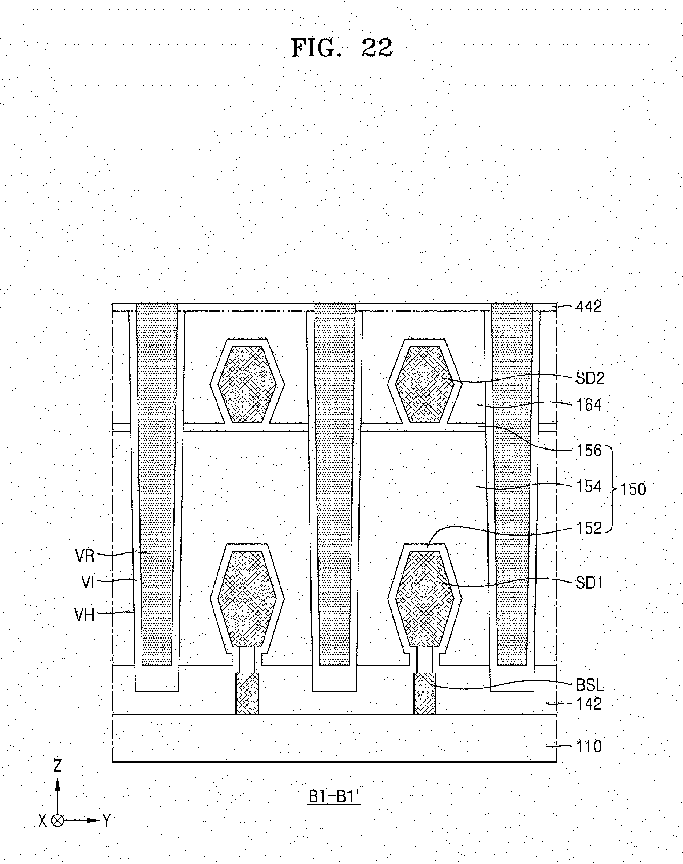

Referring to FIG. 22, a vertical conductive rail VR may be formed by filling the vertical via trenches VH, from which the sacrificial line 430 has been removed, with a conductive material.

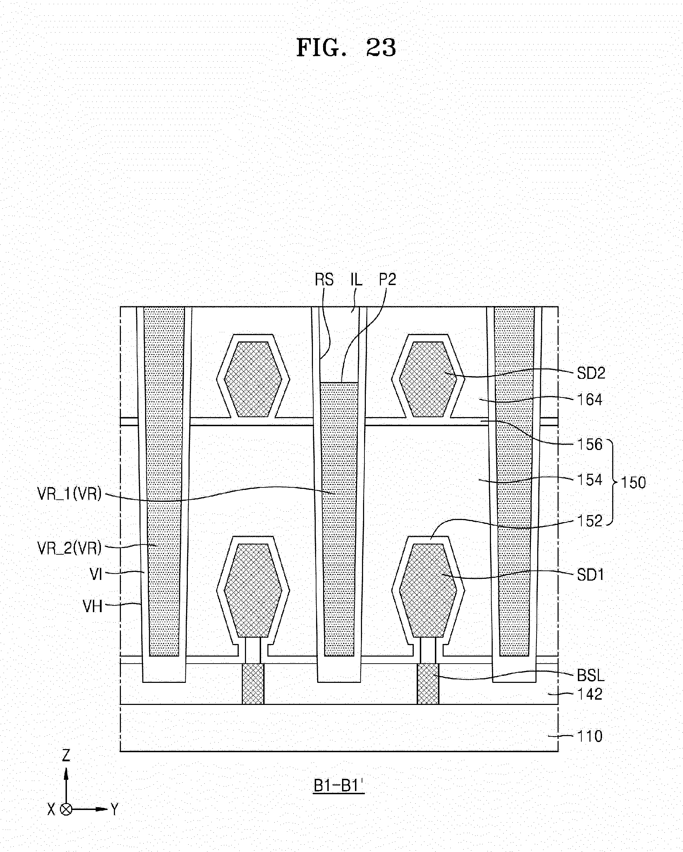

Referring to FIG. 23, a mask pattern (not shown) may be formed on the upper surface of the etch stop layer 442 and the vertical conductive rail VR, and an upper portion of the conductive rail VR provided in one or more of the vertical via trenches VH may be removed by performing a recess process by using the mask pattern as an etch mask. Accordingly, the upper side of the vertical conductive rail VR may be removed and a recess area RS may be formed. A portion of the vertical conductive rail VR whose upper surface is lowered by the recess area RS will be referred to as a second portion P2, and a portion of the vertical conductive rail VR where the recess process is not applied (for example due to the mask) and the height of the upper surface does not change will be referred to as a first portion P1 (see FIG. 6).

In embodiments, the recess process may be performed by using an etching condition suitable for lowering the upper surface of the second portion P2 of the vertical conductive rail VR to a desired height. For example, as illustrated, the upper surface of the second portion P2 of the vertical conductive rail VR may be arranged at a vertical level lower than the upper surface of the upper source/drain area SD2 and higher than the bottom surface of the upper source/drain area SD2.

The inside of the recess region RS may be filled with an isolation insulating layer IL. The isolation insulating layer IL may be formed by using at least one of, for example, silicon oxide, silicon nitride, and silicon oxynitride.

In some embodiments, the recess process may be performed until the upper surface of the second portion P2 of the vertical conductive rail VR is arranged at a lower vertical level than the bottom surface of the upper source/drain area SD2. In some embodiments, the recess process may be performed until the upper surface of the second portion P2 of the vertical conductive rail VR is arranged at a lower vertical level than the upper surface of the lower source/drain area SD1. In this case, the integrated circuit devices 100C and 100D described with reference to FIGS. 9 and 10 may be manufactured.

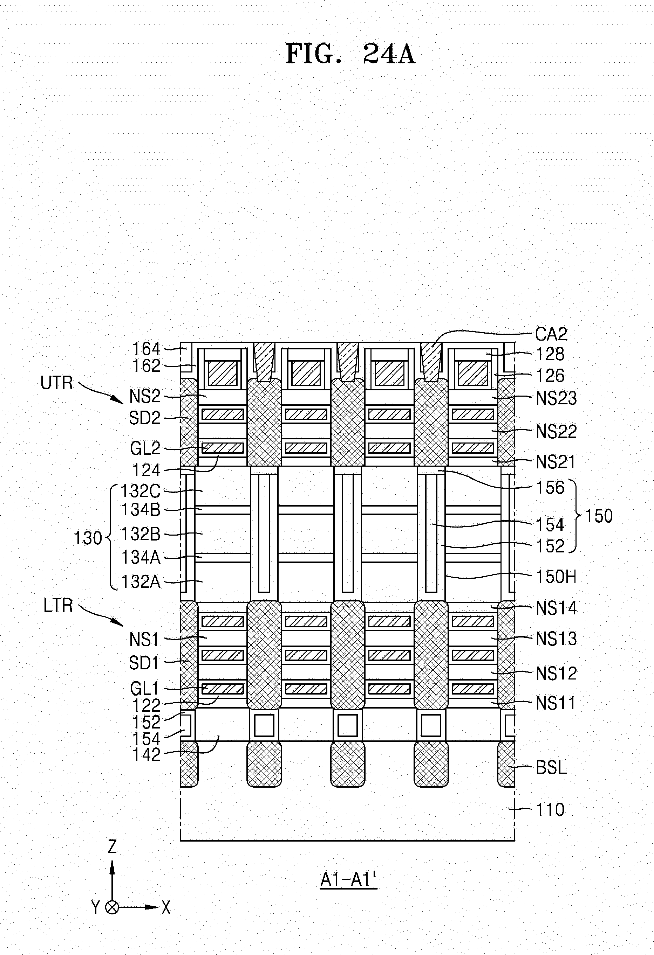

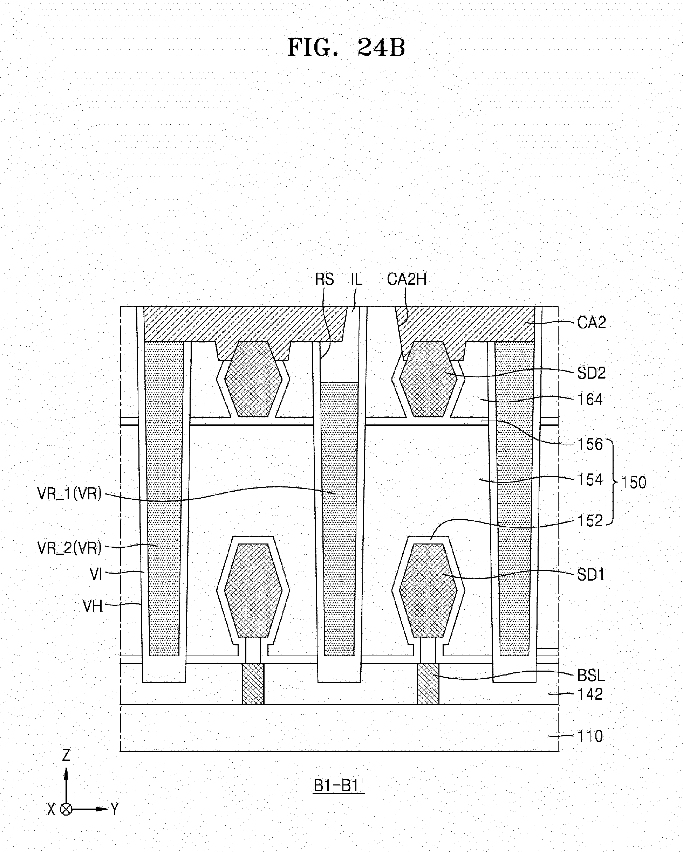

Referring to FIGS. 24A and 24B, a mask pattern may be formed over the etch stop layer 442, and an upper contact hole CA2H may be formed by removing a portion of the passivation layer 164 by using the mask pattern. The upper contact hole CA2H may be formed to a depth of exposing the upper surface of the upper source/drain area SD2.

In some embodiments, at least a portion of the upper contact hole CA2H may be arranged at a position of vertically overlapping the recess area RS and the isolation insulating layer IL. In some embodiments, by considering a process margin, the upper contact hole CA2H may be arranged close to the recess area RS to have a spacing distance smaller than a desired minimum spacing distance from the recess area RS and the isolation insulating layer IL.

An upper contact CA2 may be formed in the upper contact hole CA2H by using a conductive material. The etch stop layer 442 may be removed in a planarization process or an etch-back process for forming the upper contact CA2.

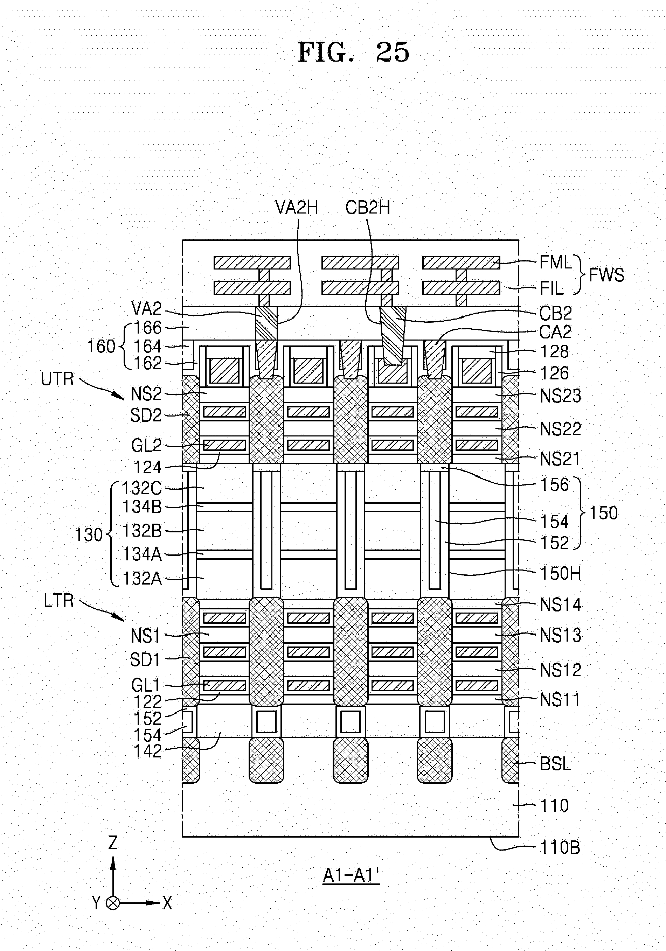

Referring to FIG. 25, an upper insulating layer 166 may be formed over the upper contact CA2 and the passivation layer 164, and an upper via hole VA2H and a gate contact hole CB2H may be formed by removing a portion of the upper insulating layer 166. An upper via VA2 and a gate contact CB2 may be formed by filling the upper via hole VA2H and the gate contact hole CB2H with a conductive material. A front line structure FWS electrically connected to the upper via VA2 and the gate contact CB2 may be formed.

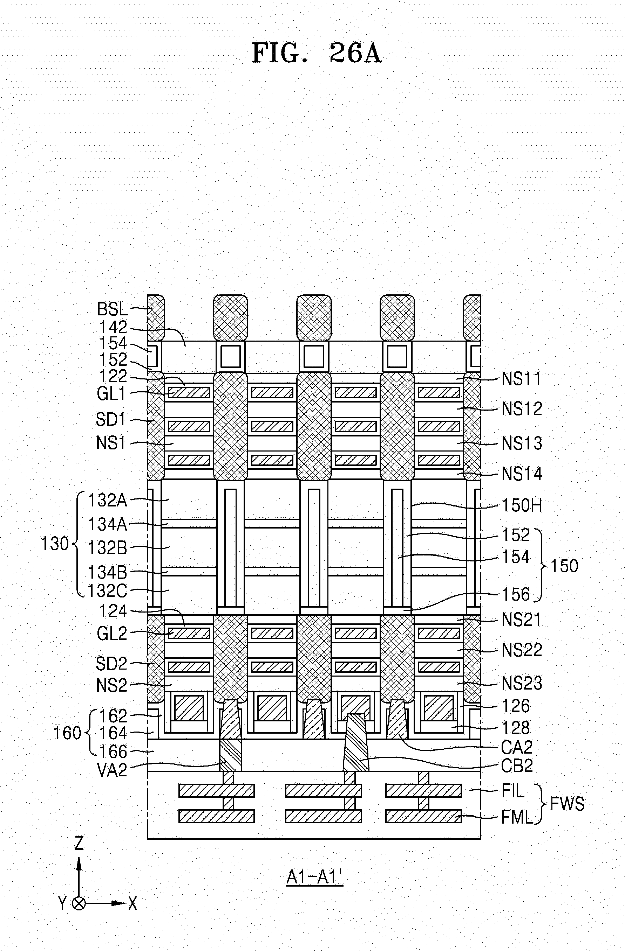

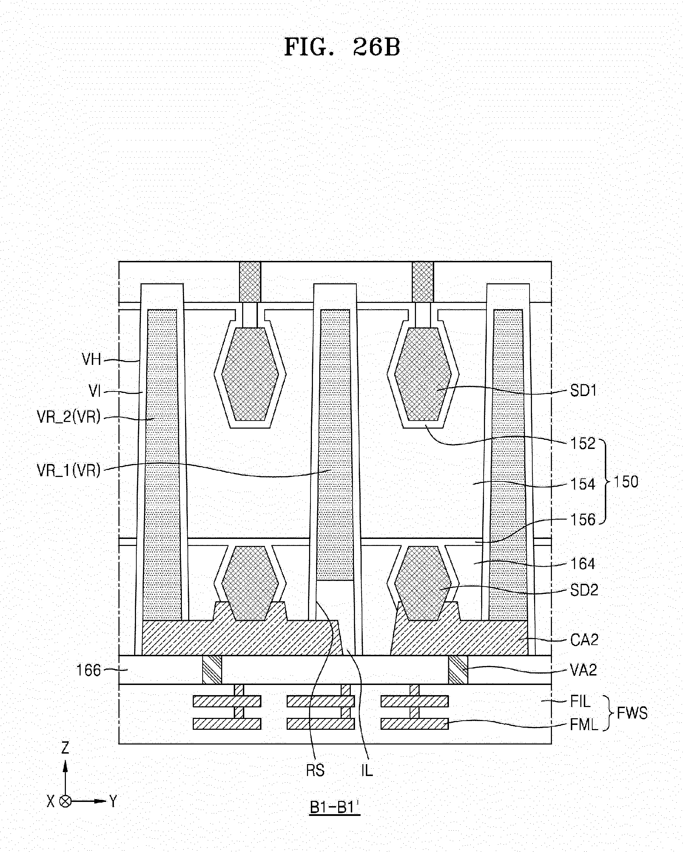

Referring to FIGS. 26A and 26B, the substrate 110 may be inverted such that the second surface 110B (see FIG. 25) of the substrate 110 faces upward, and the substrate 110 may be ground and thinned until the sacrificial layer BSL is exposed from the second surface 110B of the substrate 110.

The remaining portion of the substrate 110 may be removed by performing a wet etching process on the substrate 110. During the wet etching process, the sacrificial layer BSL may remain without being removed. After the removing of the substrate 110, the upper surface of the first base insulating layer 142 may be exposed.

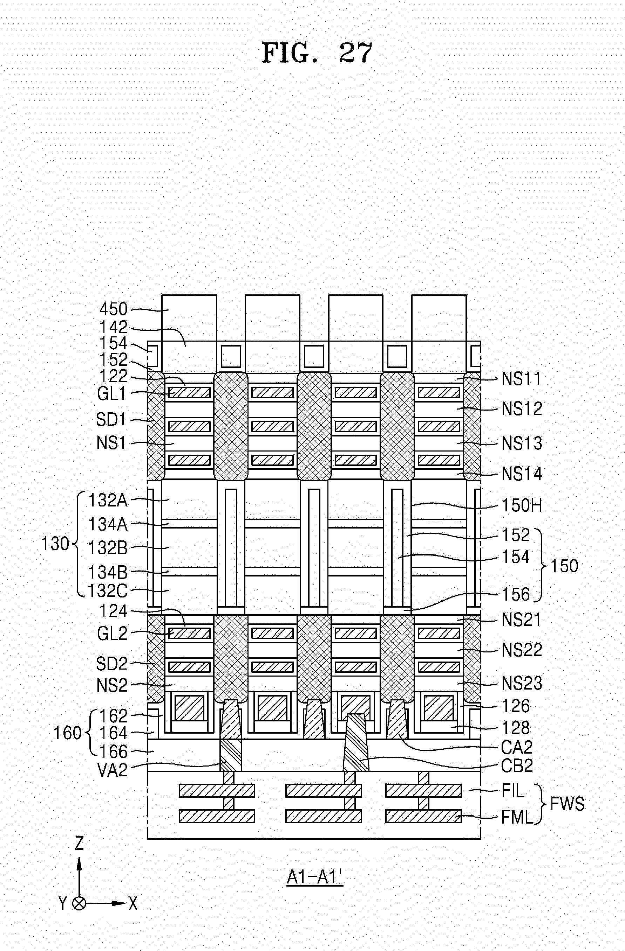

Referring to FIG. 27, a lower insulating layer 450 may be formed on the upper surface of the first base insulating layer 142 between portions of the sacrificial layer BSL, and then, the sacrificial layer BSL may be removed.

The sacrificial layer BSL may be removed, and the upper surface of the insulating line structure 150 may be exposed.

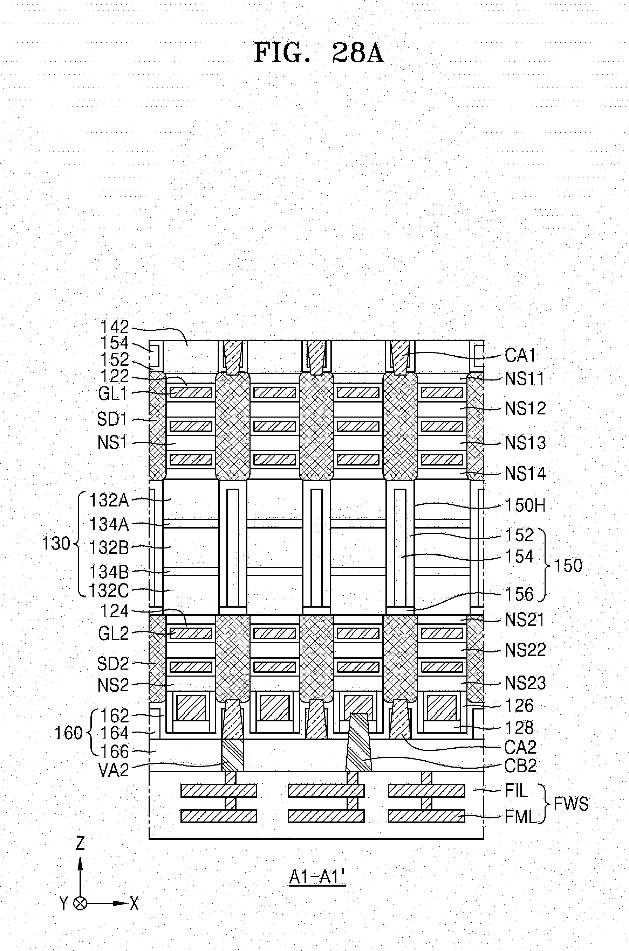

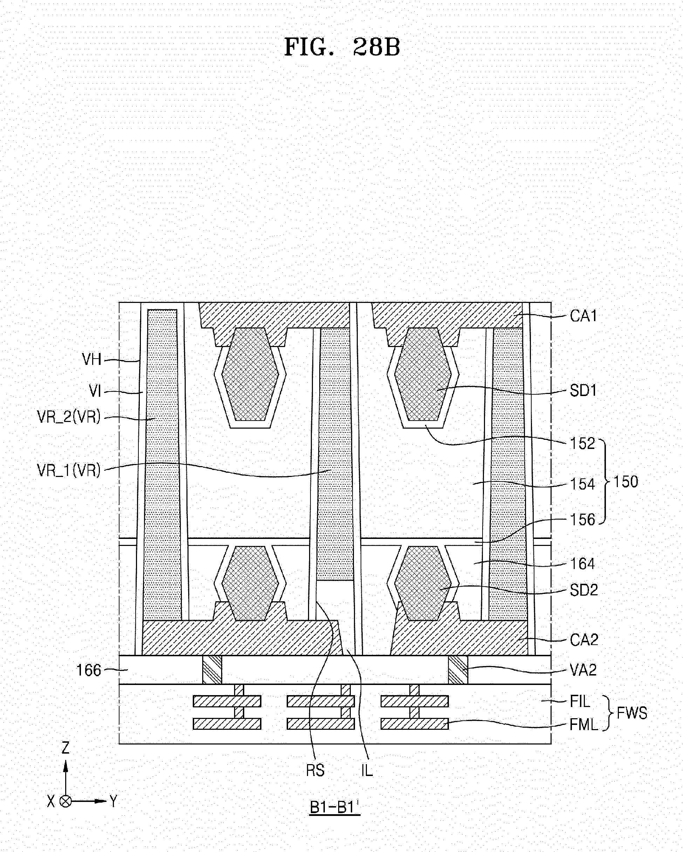

Referring to FIGS. 28A and 28B, a lower contact hole CA1H may be formed by removing a portion of the insulating line structure 150. The lower contact hole CA1H may be formed to a depth of exposing the upper surface of the lower source/drain area SD1. A lower contact CA1 may be formed by filling the lower contact hole CA1H with a conductive material.

In the process of forming the lower contact hole CA1H, an end portion of the vertical conductive rail VR may be exposed by removing an upper portion of the vertical via trench VH. In the process of forming the lower contact CA1, a portion of the lower contact CA1 may be connected to the upper surface of the vertical conductive rail VR.

Referring back to FIG. 2, a second base insulating layer 144 covering the lower contact CA1, a lower via VA1 electrically connected to the lower contact CA1, and a back line structure BWS may be formed.

An integrated circuit device 100 may be formed by the above process.

According to embodiments, the recess area RS may be formed by performing a recess process on a portion of the vertical conductive rail VR, and the upper contact CA2 may be arranged at a position of vertically overlapping at least a portion of the recess area RS (or to have a spacing distance less than or equal to a process margin from the recess area RS). Thus, because the area or the cell height required in a unit cell may be reduced, the integrated circuit device 100 may have a reduced area and may be advantageous for integration.

Embodiments if the invention may be useful, for example, in a stacked 3D structure, and a Backside Power Delivery Network (BSPDN) system. While aspects of embodiments have been particularly shown and described, it will be understood that various changes in form and details may be made therein without departing from the scope of the following claims. Embodiments of the invention encompass the following numbered clauses:
Clause 1. An integrated circuit device comprising:
   a plurality of lower source/drain areas;
   a plurality of lower contacts respectively on bottom surfaces of the plurality of lower source/drain areas;
   a plurality of upper source/drain areas spaced apart from the plurality of lower source/drain areas in a vertical direction;
   a plurality of upper contacts respectively on upper surfaces of the plurality of upper source/drain areas; and
   a first vertical conductive rail electrically connected to a first contact of the plurality of lower contacts and the plurality of upper contacts, the first vertical conductive rail extending in the vertical direction, and comprising a first portion having a first upper surface at a first vertical level and a second portion having a second upper surface at a second vertical level lower than the first vertical level,
   wherein the second portion overlaps a first upper contact among the plurality of upper contacts in the vertical direction.
Clause 2. The integrated circuit device of clause 1, wherein a bottom surface of the first upper contact is at a third vertical level higher than the second vertical level, and
   wherein the first vertical conductive rail is electrically insulated from the first upper contact.
Clause 3. The integrated circuit device of clause 2, wherein a distance between the second vertical level and the third vertical level in the vertical direction is greater than or equal to 10 nanometers.
Clause 4. The integrated circuit device of clause 1, 2, or 3 wherein the first vertical conductive rail extends in a first horizontal direction, and
wherein a first width of the second portion in the first horizontal direction is greater than a second width of the first upper contact in the first horizontal direction.
Clause 5. The integrated circuit device of any one preceding clause, wherein the first vertical conductive rail is electrically connected to a first lower contact among the plurality of lower contacts.
Clause 6. The integrated circuit device of clause 5, wherein a bottom surface of the first vertical conductive rail directly contacts the first lower contact.
Clause 7. The integrated circuit device of any one preceding clause, further comprising:
   a plurality of lower nanosheets connected to a first lower source/drain area among the plurality of lower source/drain areas and spaced apart from each other in the vertical direction;
   a lower gate line surrounding the plurality of lower nanosheets and extending in a second horizontal direction;
   a plurality of upper nanosheets connected to a first upper source/drain area among the plurality of upper source/drain areas and spaced apart from each other in the vertical direction; and
   an upper gate line surrounding the plurality of upper nanosheets and extending in the second horizontal direction.
Clause 8. The integrated circuit device of clause 7, further comprising an insulating liner on sidewalls of the first vertical conductive rail,
   wherein the lower gate line faces a sidewall of the first vertical conductive rail, and a portion of the insulating liner is between the lower gate line and the sidewall of the first vertical conductive rail, and
   wherein the upper gate line faces the sidewall of the first vertical conductive rail, and another portion of the insulating liner is between the upper gate line and the sidewall of the first vertical conductive rail.
Clause 9. The integrated circuit device of clause 7 or 8, further comprising an insulating structure between the plurality of upper source/drain areas and the plurality of lower source/drain areas, and between the upper gate line and the lower gate line,
   wherein the second upper surface of the second portion of the first vertical conductive rail is at a lower vertical level than an upper surface of the insulating structure.
Clause 10. The integrated circuit device of any one preceding clause, wherein, along the vertical direction, the second vertical level is at a lower vertical level than an upper surface of the plurality of upper source/drain areas.
Clause 11. The integrated circuit device of any one preceding clause, wherein, along the vertical direction, the second upper surface of the second portion of the first vertical conductive rail is at a lower vertical level than an upper surface of the plurality of lower source/drain areas.
Clause 12. The integrated circuit device of any one preceding clause, further comprising a second vertical conductive rail electrically connected to a second contact of the plurality of lower contacts and the plurality of upper contacts, the second vertical conductive rail extending in the vertical direction,
   wherein the second vertical conductive rail has a flat upper surface along the first vertical level.
Clause 13. The integrated circuit device of clause 12, wherein the second vertical conductive rail has a first width at the flat upper surface of the second vertical conductive rail, and
   wherein the second vertical conductive rail has a second width smaller than the first width at a bottom surface of the second vertical conductive rail.
Clause 14. An integrated circuit device comprising:
   a plurality of lower transistors, each of which comprises:
      a lower source/drain area;
      a plurality of lower nanosheets connected to the lower source/drain area and spaced apart from each other in a vertical direction;
      a lower gate line surrounding the plurality of lower nanosheets and extending in a first direction; and
      a lower contact on a bottom surface of the lower source/drain area;
   a plurality of upper transistors, each of which comprises:
      an upper source/drain area spaced apart from the lower source/drain area in the vertical direction;
      a plurality of upper nanosheets connected to the upper source/drain area and spaced apart from each other in the vertical direction;
      an upper gate line surrounding the plurality of upper nanosheets and extending in the first direction; and
      an upper contact on an upper surface of the upper source/drain area; and
   a plurality of vertical conductive rails electrically connected to the plurality of lower transistors and the plurality of upper transistors, and extending in the vertical direction, a first vertical conductive rail among the plurality of vertical conductive rails comprising:
      a first portion having a first upper surface at a first vertical level; and
      a second portion having a second upper surface at a second vertical level lower than the first vertical level along the vertical direction.
Clause 15. The integrated circuit device of clause 14, wherein the second portion of the first vertical conductive rail overlaps, along the vertical direction, a first upper contact of a first upper transistor among the plurality of upper transistors, and
   wherein the first vertical conductive rail is electrically insulated from the first upper contact.

## Claims

1. An integrated circuit device comprising:
a plurality of lower source/drain areas (SD1);
a plurality of lower contacts (CA1) respectively on bottom surfaces of the plurality of lower source/drain areas (SD1);
a plurality of upper source/drain (SD2) areas spaced apart from the plurality of lower source/drain areas (SD1) in a vertical direction;
a plurality of upper contacts (CA2) respectively on upper surfaces of the plurality of upper source/drain areas (SD2); and
a first vertical conductive rail (VR_1) electrically connected to a first lower contact (CA_1) of the plurality of lower contacts (CA1) and at least one of the plurality of upper contacts (CA2), the first vertical conductive rail (VR1) extending in the vertical direction, and comprising a first portion (P1) having a first upper surface (PU1) at a first vertical level and a second portion (P2) having a second upper surface (PU2) at a second vertical level lower than the first vertical level.

2. The integrated circuit device of claim 1, wherein the second portion (P2) overlaps a first upper contact among the plurality of upper contacts in the vertical direction.

3. The integrated circuit device of claim 1 or 2, wherein a bottom surface of the first upper contact is at a third vertical level higher than the second vertical level, and
wherein the first vertical conductive rail is electrically insulated from the first upper contact.

4. The integrated circuit device of claim 3, wherein a distance between the second vertical level and the third vertical level in the vertical direction is greater than or equal to 10 nanometers.

5. The integrated circuit device of any one of claims 1 to 4, wherein the first vertical conductive rail extends in a first horizontal direction, and
wherein a first width of the second portion in the first horizontal direction is greater than a second width of the first upper contact in the first horizontal direction.

6. The integrated circuit device of any one of claims 1 to 5, wherein a bottom surface of the first vertical conductive rail directly contacts the first lower contact.

7. The integrated circuit device of any one of claim 1 to 6, further comprising:
a plurality of lower nanosheets connected to a first lower source/drain area among the plurality of lower source/drain areas and spaced apart from each other in the vertical direction;
a lower gate line surrounding the plurality of lower nanosheets and extending in a second horizontal direction;
a plurality of upper nanosheets connected to a first upper source/drain area among the plurality of upper source/drain areas and spaced apart from each other in the vertical direction; and
an upper gate line surrounding the plurality of upper nanosheets and extending in the second horizontal direction.

8. The integrated circuit device of claim 7, further comprising an insulating liner on sidewalls of the first vertical conductive rail,
wherein the lower gate line faces a sidewall of the first vertical conductive rail, and a portion of the insulating liner is between the lower gate line and the sidewall of the first vertical conductive rail, and
wherein the upper gate line faces the sidewall of the first vertical conductive rail, and another portion of the insulating liner is between the upper gate line and the sidewall of the first vertical conductive rail.

9. The integrated circuit device of claim 7 or 8, further comprising an insulating structure between the plurality of upper source/drain areas and the plurality of lower source/drain areas, and between the upper gate line and the lower gate line,
wherein the second upper surface of the second portion of the first vertical conductive rail is at a lower vertical level than an upper surface of the insulating structure.

10. The integrated circuit device of any one of claims 1 to 9, wherein, along the vertical direction, the second vertical level is at a lower vertical level than an upper surface of the plurality of upper source/drain areas.

11. The integrated circuit device of any one of claim 1 to 10, wherein, along the vertical direction, the second upper surface of the second portion of the first vertical conductive rail is at a lower vertical level than an upper surface of the plurality of lower source/drain areas.

12. The integrated circuit device of any one of claims 1 to 11, further comprising a second vertical conductive rail electrically connected to a second contact of the plurality of lower contacts and the plurality of upper contacts, the second vertical conductive rail extending in the vertical direction,
wherein the second vertical conductive rail has a flat upper surface along the first vertical level.

13. The integrated circuit device of claim 12, wherein the second vertical conductive rail has a first width at the flat upper surface of the second vertical conductive rail, and
wherein the second vertical conductive rail has a second width smaller than the first width at a bottom surface of the second vertical conductive rail.

14. The integrated circuit device of any one of claims 1 to 13, comprising:
a plurality of lower transistors, each of which comprises:
a lower source/drain area;
a plurality of lower nanosheets connected to the lower source/drain area and spaced apart from each other in a vertical direction;
a lower gate line surrounding the plurality of lower nanosheets and extending in a first direction; and
a lower contact on a bottom surface of the lower source/drain area;
a plurality of upper transistors, each of which comprises:
an upper source/drain area spaced apart from the lower source/drain area in the vertical direction;
a plurality of upper nanosheets connected to the upper source/drain area and spaced apart from each other in the vertical direction;
an upper gate line surrounding the plurality of upper nanosheets and extending in the first direction; and
an upper contact on an upper surface of the upper source/drain area; and
a plurality of vertical conductive rails electrically connected to the plurality of lower transistors and the plurality of upper transistors, and extending in the vertical direction, a first vertical conductive rail among the plurality of vertical conductive rails comprising:
a first portion having a first upper surface at a first vertical level; and
a second portion having a second upper surface at a second vertical level lower than the first vertical level along the vertical direction.

15. The integrated circuit device of claim 14, wherein the second portion of the first vertical conductive rail overlaps, along the vertical direction, a first upper contact of a first upper transistor among the plurality of upper transistors, and
wherein the first vertical conductive rail is electrically insulated from the first upper contact.
